(19) Europäisches Patentamt
European Patent Office
Office européen des brevets

(11) **EP 4 280 234 A1**

(12) **EUROPEAN PATENT APPLICATION**
published in accordance with Art. 153(4) EPC

(43) Date of publication:
**22.11.2023 Bulletin 2023/47**

(21) Application number: **22739463.2**

(22) Date of filing: **13.01.2022**

(51) International Patent Classification (IPC):
*H01F 10/20* (2006.01)   *H01F 1/00* (2006.01)
*H01F 1/34* (2006.01)   *H01Q 17/00* (2006.01)
*H05K 9/00* (2006.01)

(52) Cooperative Patent Classification (CPC):
**H01F 1/00; H01F 1/34; H01F 10/20; H01Q 17/00;
H05K 9/00**

(86) International application number:
**PCT/JP2022/000988**

(87) International publication number:
**WO 2022/154058 (21.07.2022 Gazette 2022/29)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **14.01.2021   JP 2021004514
07.01.2022   JP 2022001607**

(71) Applicant: **Powdertech Co., Ltd.
Kashiwa-shi, Chiba 277-8557 (JP)**

(72) Inventors:
• **ISHII, Kazutaka
Kashiwa-shi, Chiba 277-8557 (JP)**
• **AGA, Koji
Kashiwa-shi, Chiba 277-8557 (JP)**

(74) Representative: **Vossius & Partner
Patentanwälte Rechtsanwälte mbB
Siebertstraße 3
81675 München (DE)**

(54) **MAGNETIC COMPOSITE**

(57)    Provided is a magnetic composite including a ferrite layer that is dense, has a relatively large thickness, is excellent in magnetic properties and electrical properties, and further has good adhesion.

The magnetic composite includes a metal base material and a ferrite layer provided on a surface of the metal base material. In the magnetic composite, the metal base material has a thickness ($d_M$) of 20 $\mu$m or more, and the ferrite layer has a thickness ($d_F$) of 2.0 $\mu$m or more, contains spinel-type ferrite as a principal component, and has a ratio ($I_{222}/I_{311}$) of 0.00 or more and 0.03 or less, the ratio being of an integrated intensity ($I_{222}$) of a (222) plane to an integrated intensity ($I_{311}$) of a (311) plane in X-ray diffraction analysis.

*FIG. 15*

EP 4 280 234 A1

**Description**

TECHNICAL FIELD

The present invention relates to a magnetic composite.

BACKGROUND ART

With a rapid progress of electronic information and communication technology in recent years, utilization of electromagnetic waves is rapidly increasing, and frequency increasing and band widening of electromagnetic waves to be used have been advancing. Specifically, in addition to a system in a quasi-microwave band represented by mobile phones (1.5, 2.0 GHz) and a wireless LAN (2.45 GHz), introduction of a new system utilizing radio waves in an extremely high frequency band such as a high-speed wireless LAN (65 GHz) and a collision-prevention radar (76.5 GHz) is advancing.

As utilization extension and the frequency increasing of the electromagnetic waves are advanced, problems of electromagnetic interference such as malfunction of an electronic device and an adverse effect on a human body caused by electromagnetic noise are closed up, and there is an increasing demand for a countermeasure against electromagnetic compatibility (EMC). As a method for the countermeasure against EMC, there is known a method of absorbing unnecessary electromagnetic waves using an electromagnetic wave absorber (radio wave absorber) to prevent intrusion of the electromagnetic waves.

For the electromagnetic wave absorber, a material exhibiting conductive loss, dielectric loss, and/or magnetic loss is used. As a material exhibiting magnetic loss, ferrite having high permeability and high electric resistance is frequently used. The ferrite causes a resonance phenomenon at a specific frequency to absorb an electromagnetic wave, converts absorbed electromagnetic wave energy into thermal energy, and radiates the thermal energy to an outside. As an electromagnetic wave absorber using ferrite, a composite material or a ferrite thin film containing ferrite powder and a binder resin has been proposed. In addition, a technique of forming a ferrite film on a substrate is known in applications other than the electromagnetic wave absorber.

For example, Patent Literature 1 discloses that a coated metal sheet is prepared by applying a coating composition containing 20 mass% to 80 mass% of ferrite powder such as Mn-Zn ferrite, 3 mass% to 60 mass% of carbon black powder, and a resin as the remainder on at least one surface of a metal sheet (claims 1 to 6 in Patent Literature 1). In addition, Patent Literature 1 discloses that the coating composition has excellent heat dissipation and good electromagnetic wave absorption performance in a wide frequency band (paragraph [0060] in Patent Literature 1).

Patent Literature 2 discloses an electromagnetic wave absorber having a ferromagnetic material physically deposited on a substrate made of an organic macromolecular, and discloses that the electromagnetic wave absorber has good electromagnetic wave absorption properties, a small size, light weight, flexibility, and fastness (claim 1 and paragraph [0008] in Patent Literature 2). In addition, Patent Literature 2 discloses that an oxide-based soft magnetic material is mainly used as the ferromagnetic material, ferrite is preferable as the oxide-based soft magnetic material, and examples of physical vapor deposition include EB vapor deposition, ion plating, magnetron sputtering, and counter target type magnetron sputtering (paragraphs [0009], [0010], and [0017] in Patent Literature 2).

Patent Literature 3 discloses a composite magnetic film having an electromagnetic wave absorption function, which includes a magnetic phase constituting of a metal magnetic material and a high electric resistance phase of high insulating ferrite dispersed in an island shape in the magnetic phase (claim 1 in Patent Literature 3). In addition, Patent Literature 3 discloses that the composite magnetic film is formed by an aerosol deposition (AD) method in which raw material fine particle powder is aerosolized, and is caused to collide with a substrate or the like which is a film-forming material to form a thick film, and that by applying the AD method, a composite magnetic film having a desired film thickness can be formed at a high speed (paragraphs [0029] and [0033] in Patent Literature 3).

Patent Literature 4 discloses an electromagnetic wave absorber that is a composite in which metal particles are dispersed in a ceramic parent phase such as ferrite (claims 1 and 8 in Patent Literature 4). In addition, Patent Literature 4 discloses that the electromagnetic wave absorber is often used by being formed on a substrate, and in this case, when a metal is the substrate, electromagnetic waves are reflected at an interface between the electromagnetic wave absorber and the substrate, and can be expected to be absorbed in the electromagnetic wave absorber again, and that a gas deposition method or an aerosol deposition method can be used to manufacture the electromagnetic wave absorber (paragraphs [0029] and [0031] in Patent Literature 4).

As described above, in Patent Literatures 1 to 4, it is proposed to prepare an electromagnetic wave absorber by forming a ferrite-containing layer on a substrate such as a metal sheet. On the other hand, in applications other than the electromagnetic wave absorber, it has been proposed to form a ferrite-containing layer on a substrate. For example, Patent Literature 5 discloses an inductor element including a magnetic substrate, a coil formed on a surface of the magnetic substrate by a conductor, and a magnetic layer formed on the magnetic substrate by an aerosol deposition method so as to embed the coil (claim 1 in Patent Literature 5).

PRIOR ART DOCUMENTS

PATENT LITERATURES

Patent Literature 1: JP2004-027064A

Patent Literature 2: JP2005-045193A

Patent Literature 3: JP2007-088121A

Patent Literature 4: JP2007-180289A

Patent Literature 5: JP2007-250924A

SUMMARY OF INVENTION

PROBLEM TO BE SOLVED BY THE INVENTION

Although it has been proposed to apply a composite prepared by forming a ferrite-containing layer on a substrate to applications of electronic devices including an electromagnetic wave absorber and an inductor, there is room for improvement in techniques in the conventional art. For example, a composite material containing the ferrite powder proposed in Patent Literature 1 is inferior in magnetic properties because the composite material contains a large amount of resin that is nonmagnetic. Therefore, there is a limit in enhancing electromagnetic wave absorption properties. Regarding the ferrite thin film proposed in Patent Literature 2, it is difficult to form the ferrite thin film to be thick in view of manufacture, and there is a limit in enhancing properties such as magnetic properties. In addition, even when a thick film can be formed, there is a problem in that the film is easily peeled off from a base material. Since the composites proposed in Patent Literatures 3 and 4 include a highly conductive metal magnetic material, the complexes cannot be applied to applications requiring electric insulation. Further, the element proposed in Patent Literature 5 also has a limit in enhancing properties such as electrical properties and adhesion.

The present inventors have conducted intensive studies in view of such problems. As a result, it was found that in the magnetic composite including the metal base material and the ferrite layer, a crystalline state of the ferrite layer is important, and by controlling the crystalline state, it is possible to obtain a ferrite layer that is dense, has a relatively large thickness, is excellent in magnetic properties, electrical properties, and heat resistance, and further has good adhesion.

The present invention has been accomplished on the basis of such findings, and an object of the present invention is to provide a magnetic composite including a ferrite layer that is dense, has a relatively large thickness, is excellent in magnetic properties (tan$\delta$ is small at a high frequency of 500 MHz or more), electrical properties (surface resistance is high without being affected by the metal base material), and heat resistance, and further has good adhesion.

MEANS FOR SOLVING THE PROBLEM

The present invention encompasses the following embodiments (1) to (6). In the present description, the expression "to" includes numerical values at both ends thereof. Thus, "X to Y" has the same meaning as "X or more and Y or less".

(1) A magnetic composite including a metal base material and a ferrite layer provided on a surface of the metal base material, in the magnetic composite,

the metal base material has a thickness ($d_M$) of 0.001 $\mu$m or more, and
the ferrite layer has a thickness ($d_F$) of 2.0 $\mu$m or more, contains spinel-type ferrite as a principal component, and has a ratio ($I_{222}/I_{311}$) of 0.00 or more and 0.03 or less, the ratio being of an integrated intensity ($I_{222}$) of a (222) plane to an integrated intensity ($I_{311}$) of a (311) plane in X-ray diffraction analysis.

(2) The magnetic composite according to the above-mentioned (1), in which in the ferrite layer, a content of $\alpha$-$Fe_2O_3$

is 0.0 mass% or more and 20.0 mass% or less.

(3) The magnetic composite according to the above-mentioned (1) or (2), in the magnetic composite, the ferrite layer contains iron (Fe) and oxygen (O), and further contains at least one element selected from the group consisting of lithium (Li), magnesium (Mg), aluminum (Al), titanium (Ti), manganese (Mn), zinc (Zn), nickel (Ni), copper (Cu), and cobalt (Co).

(4) The magnetic composite according to any one of the above-mentioned (1) to (3), in which in the ferrite layer, a ratio ($Ra/d_F$) of a surface arithmetic average roughness (Ra) to the thickness ($d_F$) is more than 0.00 and 0.20 or less.

(5) The magnetic composite according to any one of the above-mentioned (1) to (4), in the magnetic composite, the ferrite layer has a composition including a ferrite component and the remainder being inevitable impurities.

(6) An element or component having a coil and/or an inductor function, an electronic device, an electronic component accommodation housing, an electromagnetic wave absorber, an electromagnetic wave shield, or an element or component having an antenna function, which includes the magnetic composite according to any one of the above-mentioned (1) to (5).

EFFECTS OF INVENTION

According to the present invention, there is provided a magnetic composite including a ferrite layer that is dense, has a relatively large thickness, is excellent in magnetic properties and electrical properties, and further has good adhesion.

BRIEF DESCRIPTION OF DRAWINGS

Fig. 1 illustrates an embodiment of a magnetic composite.
Fig. 2 illustrates another embodiment of the magnetic composite.
Fig. 3 illustrates yet another embodiment of the magnetic composite.
Fig. 4 illustrates still another embodiment of the magnetic composite.
Fig. 5 illustrates an example in which the magnetic composite is applied to an inductor.
Fig. 6 illustrates an example in which the magnetic composite is applied to an LC filter.
Fig. 7 illustrates another example in which the magnetic composite is applied to an inductor.
Fig. 8 illustrates an example in which the magnetic composite is applied to a magnetic sensor.
Fig. 9 illustrates an example in which the magnetic composite is applied to an antenna element (UHF-ID tag).
Fig. 10 illustrates an example in which the magnetic composite is applied to an electromagnetic wave absorber.
Fig. 11 illustrates an example in which the magnetic composite is applied to an electronic component accommodation housing.
Fig. 12 illustrates an example in which the magnetic composite is used for a cable coating material.
Fig. 13 illustrates an example in which the magnetic composite is applied to a winding-type inductor.
Fig. 14 illustrates an example in which the magnetic composite is applied to a temperature sensor.
Fig. 15 illustrates an example of a configuration of an aerosol deposition film forming device.
Fig. 16 illustrates cross-sectional element mapping images of a ferrite layer obtained in Example 2.
Fig. 17 is a graph illustrating a temperature dependence of saturation magnetization of a magnetic composite obtained in Example 2.
Fig. 18 is a graph illustrating a temperature dependence of saturation magnetization of a magnetic composite obtained in Example 10.
Fig. 19 is a graph illustrating a temperature dependence of saturation magnetization of a magnetic composite obtained in Example 14.
Fig. 20 is a graph illustrating a temperature dependence of saturation magnetization of a magnetic composite obtained in Example 15.
Fig. 21 illustrates permeability (real part $\mu'$ and imaginary part $\mu''$) of the magnetic composite obtained in Example 2.

EMBODIMENTS FOR CARRYING OUT THE INVENTION

A specific embodiment of the present invention (hereinafter referred to as "the present embodiment") will be described. The present invention is not limited to the following embodiment, and various modifications can be made without departing from the gist of the present invention.

«1. Magnetic Composite»

The magnetic composite of the present embodiment includes a metal base material and a ferrite layer provided on the metal base material. The metal base material has a thickness ($d_M$) of 0.001 $\mu$m or more. The ferrite layer has a thickness ($d_F$) of 2.0 $\mu$m or more. In addition, the ferrite layer contains spinel-type ferrite as a principal component, and has a ratio ($I_{222}/I_{311}$) of 0.00 or more and 0.03 or less, the ratio being of an integrated intensity ($I_{222}$) of a (222) plane to an integrated intensity ($I_{311}$) of a (311) plane in X-ray diffraction analysis. The magnetic composite will be described in detail below.

The metal base material functions as a support for the magnetic composite. A shape of the metal base material is not particularly limited as long as the metal base material functions as a support. For example, the shape may be a plate shape, a foil shape, a rod shape, a box shape, a yarn shape, or a strip shape. In addition, the metal base material can function as an electrode since it has conductivity. Further, in a case where the magnetic composite is used for an application of an electromagnetic wave absorber, the metal base material can be made to function as a reflector of an electromagnetic wave. Thus, when the ferrite layer of the magnetic composite faces an electromagnetic wave incident side, a part of the electromagnetic wave is incident on the ferrite layer. Intensity of the incident electromagnetic wave attenuates while passing through the ferrite layer. The attenuated electromagnetic wave is reflected by a surface of the metal base material, passes through the ferrite layer again, and is radiated from the surface.

A metal constituting the metal base material is not particularly limited. The metal may be a simple metal or an alloy. Preferably, the metal is at least one selected from the group consisting of copper (Cu), aluminum (Al), nickel (Ni), iron (Fe), cobalt (Co), chromium (Cr), gold (Au), and silver (Ag). These metals are inexpensive. The metal may be at least one selected from the group consisting of nickel (Ni), iron (Fe), and cobalt (Co). The metal base material is more preferably a ferromagnetic material. By using a ferromagnetic metal base material, a synergy with excellent magnetic properties of the ferrite layer can be exhibited.

The metal base material may be constituted of only a metal, or may be a laminate of a non-metal base material and a metal layer. In this case, the metal layer laminated on the non-metal base material corresponds to the metal base material. A resin film such as a PET film can be used as the non-metal base material. The metal layer may be formed on the non-metal base material by a thin film forming method.

The thickness ($d_M$) of the metal base material is limited to 0.001 $\mu$m or more. When the metal base material is excessively thin, there is a concern that an effect of the metal base material cannot be sufficiently obtained depending on a frequency to be applied. The thickness of the metal base material is preferably 0.01 $\mu$m or more, more preferably 0.1 $\mu$m or more, still more preferably 1 $\mu$m or more, and particularly preferably 10 $\mu$m or more. On the other hand, an upper limit of the thickness is not limited. However, by appropriately thinning the metal base material, flexibility can be imparted to the magnetic composite. This effect is particularly remarkable when a metal base material is used. The thickness may be 1,000 $\mu$m or less, 500 $\mu$m or less, 200 $\mu$m or less, 100 $\mu$m or less, or 50 $\mu$m or less. In addition, the metal base material may have a yarn shape, a strip shape, and a plate shape, or may have a foil shape. However, the metal base material is preferably to have the foil shape. For example, by using a foil-shaped metal base material (metal foil), a magnetic composite having excellent flexibility can be prepared.

The ferrite layer of the present embodiment is a polycrystalline containing spinel-type ferrite as a principal component. Thus, the ferrite layer is an aggregate of crystal grains constituting of the spinel-type ferrite. The spinel-type ferrite is a composite oxide of iron (Fe) having a spinel-type crystal structure, most of which exhibit soft magnetism. By including a layer containing the spinel-type ferrite as a principal component, the magnetic composite has excellent magnetic properties. A type of the spinel-type ferrite is not particularly limited. Examples thereof include at least one selected from the group consisting of manganese (Mn) ferrite, manganese-zinc (Mn-Zn) ferrite, magnesium (Mg) ferrite, magnesium-zinc (Mg-Zn) ferrite, nickel (Ni) ferrite, nickel-copper (Ni-Cu) ferrite, nickel-copper-zinc (Ni-Cu-Zn) ferrite, cobalt (Co) ferrite, and cobalt-zinc (Co-Zn) ferrite. In the present description, the principal component refers to a component having a content of 50.0 mass% or more. In order to utilize the excellent magnetic properties of the spinel-type ferrite, a content ratio of the spinel-type ferrite (ferrite phase) in the ferrite layer is preferably 60.0 mass% or more, more preferably 70.0 mass% or more, still more preferably 80.0 mass% or more, and particularly preferably 90.0 mass% or more.

The thickness ($d_F$) of the ferrite layer of the present embodiment is limited to 2.0 $\mu$m or more. When the ferrite layer is excessively thin, a thickness of the ferrite layer becomes non-uniform, and there is a concern that magnetic properties and electrical properties (electric insulation) deteriorate. The thickness is preferably 3.0 $\mu$m or more, and more preferably 4.0 $\mu$m or more. An upper limit of the thickness is not limited. However, it is difficult to form a film of an excessively thick ferrite layer while maintaining density thereof. In addition, when the ferrite layer is excessively thick, internal stress of the ferrite layer becomes excessively large, and there is a concern that the ferrite layer is peeled off. Further, when flexibility is imparted to the magnetic composite, it is desirable that the ferrite layer is appropriately thin. The thickness is preferably 100.0 $\mu$m or less, more preferably 50.0 $\mu$m or less, still more preferably 20.0 $\mu$m or less, and particularly preferably 10.0 $\mu$m or less.

In the ferrite layer of the present embodiment, the ratio ($I_{222}/I_{311}$) of the integrated intensity ($I_{222}$) of the (222) plane to the integrated intensity ($I_{311}$) of the (311) plane in the X-ray diffraction (XRD) analysis is 0.00 or more and 0.03 or less ($0.00 \leq I_{222}/I_{311} \leq 0.03$). Thus, when the ferrite layer is analyzed by an X-ray diffraction method, a diffraction peak based on the (222) plane of a spinel phase is hardly observed in an X-ray diffraction profile. This is because the crystal grains constituting the ferrite layer are constituted of microcrystals. The crystal grains of the ferrite layer of the present embodiment undergo plastic deformation during manufacturing of the magnetic composite. Therefore, a crystallite diameter is small, and distribution of lattice constants is wide. As a result, an XRD peak becomes broad, and the (222) diffraction peak is not observed. $I_{222}/I_{311}$ is preferably 0.02 or less, and more preferably 0.01 or less. In contrast, a common spinel-type ferrite material has high crystallinity even in a polycrystalline state. Therefore, the (222) plane diffraction peak is relatively strongly observed. Specifically, an XRD peak intensity ratio ($I_{222}/I_{311}$) is about 0.04 to 0.05 (4% to 5%).

The ferrite layer of the present embodiment having a small XRD peak intensity ratio ($I_{222}/I_{311}$) is characterized by being dense. This is because the crystal grains undergone the plastic deformation are easily densely packed. In addition, the ferrite layer of the present embodiment has an effect of being excellent in adhesion to the metal base material. This is because a contact area with the metal base material is increased by the plastic deformation of the crystal grains. In addition, it is considered that the reason also includes that bonding to a metal constituting the base material becomes strong due to the small crystallite diameter and a crystal structure in which the periodicity is disturbed. Further, the ferrite layer of the present embodiment has small magnetic loss ($\tan\delta$) in a high-frequency region of 500 MHz or more. It is presumed that the reason is that a correlation length of a magnetic moment becomes short due to the small crystallite diameter, and as a result, magnetic domain wall displacement is smoothly performed in the high-frequency region. In contrast, in a common spinel-type ferrite material, the correlation length of the magnetic moment is long. The magnetic domain wall displacement by an external magnetic field can be performed in a low-frequency region, but in a high-frequency region of 100 MHz or more, the magnetic domain wall displacement cannot follow fluctuation of the external magnetic field, and the magnetic loss increases.

Preferably, the crystallite diameter of the ferrite layer is 1 nm or more and 10 nm or less. By reducing the crystallite diameter to 10 nm or less, the density and the adhesion of the ferrite layer are further increased, and an effect of preventing an increase in magnetic loss is further remarkable. In addition, by setting the crystallite diameter to 1 nm or more, it is possible to prevent the ferrite layer from becoming amorphous and the magnetic properties from deteriorating. The crystallite diameter is more preferably 1 nm or more and 5 nm or less, and still more preferably 1 nm or more and 2 nm or less.

Preferably, a lattice constant of the spinel-type ferrite contained in the ferrite layer is 8.30 Å or more and 8.80 Å or less. By setting the lattice constant to 8.30 Å or more and 8.80 Å or less, an effect of enhancing magnetic properties of raw material grains can be obtained. The lattice constant is more preferably 8.30 Å or more and 8.60 Å or less, and still more preferably 8.30 Å or more and 8.50 Å or less.

Preferably, a ratio ($d_F/d_M$) of the thickness ($d_F$) of the ferrite layer to the thickness ($d_M$) of the metal base material is 0.05 or more and 200 or less ($0.05 \leq d_F/d_M \leq 200$). When the thickness ratio ($d_F/d_M$) is excessively small, the thickness of the ferrite layer becomes non-uniform, and the magnetic properties and the electrical properties (electric insulation) deteriorate. The thickness ratio ($d_F/d_M$) is more preferably 0.10 or more. On the other hand, when the thickness ratio ($d_F/d_M$) is excessively large, the metal base material cannot resist the internal stress of the ferrite layer, and the composite may be curved. The thickness ratio ($d_F/d_M$) is more preferably 10.0 or less, still more preferably 1.00 or less, particularly preferably 0.50 or less, and most preferably 0.30 or less.

When the base material is a laminate constituted of a plurality of layers, a thickness of a layer in direct contact with the ferrite layer corresponds to the thickness of the base material. When the base material is uneven, an arithmetic mean of the thinnest portion and the thickest portion of the base material on which the ferrite layer is formed is defined as the thickness $d_M$ of the base material, and a difference between an arithmetic mean of the thinnest portion and the thickest portion of the composite and the thickness $d_M$ of the base material is defined as the thickness $d_F$ of the ferrite layer. When ferrite layers are formed on both surfaces of the composite, the difference between the arithmetic mean of the thinnest portion and the thickest portion of the composite and the thickness $d_M$ of the base material is regarded as twice the thickness of the ferrite layer, and the thickness $d_F$ is calculated. When the thickness $d_M$ of the base material exceeds 2,000 µm, the thickness ratio ($d_F/d_M$) is calculated by regarding the thickness $d_M$ of the base material as 2,000 µm.

Preferably, in the ferrite layer, a content of $\alpha$-$Fe_2O_3$ (hematite) is 0.0 mass% or more and 20.0 mass% or less. The $\alpha$-$Fe_2O_3$ is a free iron oxide that did not become a spinel phase. Unlike the spinel phase which is a ferromagnetic material, $\alpha$-$Fe_2O_3$ is a paramagnetic material. Therefore, when an amount of $\alpha$-$Fe_2O_3$ is excessively large, the magnetic properties of the ferrite layer may deteriorate. The amount of $\alpha$-$Fe_2O_3$ is more preferably 15.0 mass% or less, and still more preferably 10.0 mass% or less. Meanwhile, $\alpha$-$Fe_2O_3$ is a stable compound having high electric resistance. By appropriately containing $\alpha$-$Fe_2O_3$ in the ferrite layer, a conductive path in the ferrite layer can be disconnected, and the electric resistance can be further increased. In particular, the manganese (Mn) ferrite and the manganese-zinc (Mn-Zn) ferrite contain manganese (Mn) ions and iron (Fe) ions having unstable coefficients, and thus tend to have low electric resistance. Accordingly, by containing $\alpha$-$Fe_2O_3$ in the ferrite, an effect of improving the electric resistance can be remarkably exhibited. In addition, by appropriately containing $\alpha$-$Fe_2O_3$, densification of the ferrite layer and improvement in adhesion can be achieved. The $\alpha$-$Fe_2O_3$ is generated in a film forming process of a ferrite layer during the manufacturing of the magnetic composite. Thus, the plastic deformation and reoxidation of the ferrite crystal grains occur when the film forming process is performed, and $\alpha$-$Fe_2O_3$ is generated. The plastic deformation and the reoxidation play an important role for densification of the ferrite layer and enhancement of the adhesion. Therefore, the ferrite layer appropriately containing $\alpha$-$Fe_2O_3$ has high density and adhesion. The amount of $\alpha$-$Fe_2O_3$ is more preferably 0.1 mass% or more, still more preferably 1.0 mass% or more, and particularly preferably 5.0 mass% or more.

Preferably, the ferrite layer contains iron (Fe) and oxygen (O), and further contains at least one element selected from the group consisting of lithium (Li), magnesium (Mg), aluminum (Al), titanium (Ti), manganese (Mn), zinc (Zn), nickel (Ni), copper (Cu), and cobalt (Co). The elements contained in the ferrite layer can be confirmed using an analysis method/analysis device such as ICP, EDX, SIMS, and/or XRF.

Preferably, in the ferrite layer, a ratio ($Ra/d_F$) of a surface arithmetic average roughness (Ra) to the thickness ($d_F$) is more than 0.00 and 0.20 or less ($0.00 < Ra/d_F \leq 0.20$). When the roughness ratio ($Ra/d_F$) is excessively large, the thickness of the ferrite layer tends to be non-uniform. Therefore, an electric field is locally concentrated when a high voltage is applied, and a leakage current may be generated. The roughness ratio ($Ra/d_F$) is more preferably more than 0.00 and 0.10 or less, and still more preferably more than 0.00 and 0.05 or less.

The ferrite layer of the present embodiment has a relatively high density. The reason is that the ferrite crystal grains constituting the ferrite layer were repeatedly subjected to the plastic deformation, and as a result, small crystal grains were deposited as the ferrite layer. A relative density of the ferrite layer (density of ferrite layer/true specific gravity of ferrite powder) is preferably 0.60 or more, more preferably 0.70 or more, still more preferably 0.80 or more, particularly preferably 0.90 or more, most preferably 0.95 or more. By increasing the density, an effect of improving the magnetic properties, the electrical properties, and the adhesion of the ferrite layer becomes more remarkable.

The ferrite layer of the present embodiment has a relatively high electric resistance. The reason is that since the density of the ferrite layer is high, adsorption of a conductive component such as moisture which causes deterioration in electric resistance is small. It is also considered that the small crystallite diameter of the ferrite crystal grains constituting the ferrite layer has an effect thereon. Actually, a common Mn-Zn ferrite material is considered to have relatively low electric resistance, and a volume resistance thereof is about $10^4$ $\Omega$·cm to $10^5$ $\Omega$·cm. In contrast, the ferrite layer of the present embodiment exhibits a higher resistance value, and a cause thereof can be found in a size of the crystallite diameter. Further, by containing an appropriate amount of $\alpha$-$Fe_2O_3$, the electric resistance of the ferrite layer can be further increased. A surface resistance of the ferrite layer is preferably $10^4$ $\Omega$ or more, and more preferably $10^5$ $\Omega$ or more. By increasing the surface resistance, the insulation property of the ferrite layer can be made excellent, and in a case where the magnetic composite is applied to a device, problems such as generation of an eddy current can be prevented.

The ferrite layer preferably has a composition including a ferrite component and the remainder being inevitable impurities. Thus, it is preferable that organic components and inorganic components other than the ferrite component are not contained in excess of an amount of the inevitable impurities. The ferrite layer of the present embodiment can be made sufficiently dense without adding a resin component such as a binder or an inorganic additive component such as a sintering aid. By limiting a content of a nonmagnetic material to the minimum, excellent magnetic properties based on ferrite can be sufficiently utilized. The ferrite component is a component constituting the spinel-type ferrite as a principal component. For example, in a case where the ferrite layer contains manganese-zinc (Mn-Zn) ferrite as the principal component, the ferrite component includes iron (Fe), manganese (Mn), zinc (Zn), and oxygen (O). In a case where the ferrite layer contains nickel-copper-zinc (Ni-Cu-Zn) ferrite as the principal component, the ferrite component includes iron (Fe), nickel (Ni), copper (Cu), zinc (Zn), and oxygen (O). Further, the inevitable impurities are components that are inevitably mixed during manufacturing, and a content thereof is typically 1,000 ppm or less. In particular, the ferrite layer preferably contains no metal component other than an oxide.

The magnetic composite is preferably manufactured by a method including: a process (preparation process) of preparing a metal base material and a spinel-type ferrite powder having an average particle diameter (D50) of 1.0 $\mu$m or more and 10.0 $\mu$m or less; and a process (film forming process) of forming a film of the ferrite powder on a surface of the metal base material by an aerosol deposition method, and in the method, a ratio ($LCf/LCp$) of a lattice constant (LCf) of a spinel phase contained in a ferrite layer to a lattice constant (LCp) of a spinel phase contained in the spinel-type ferrite powder is 0.95 or more and 1.0.5 or less ($0.95 \leq LCf/LCp \leq 1.05$).

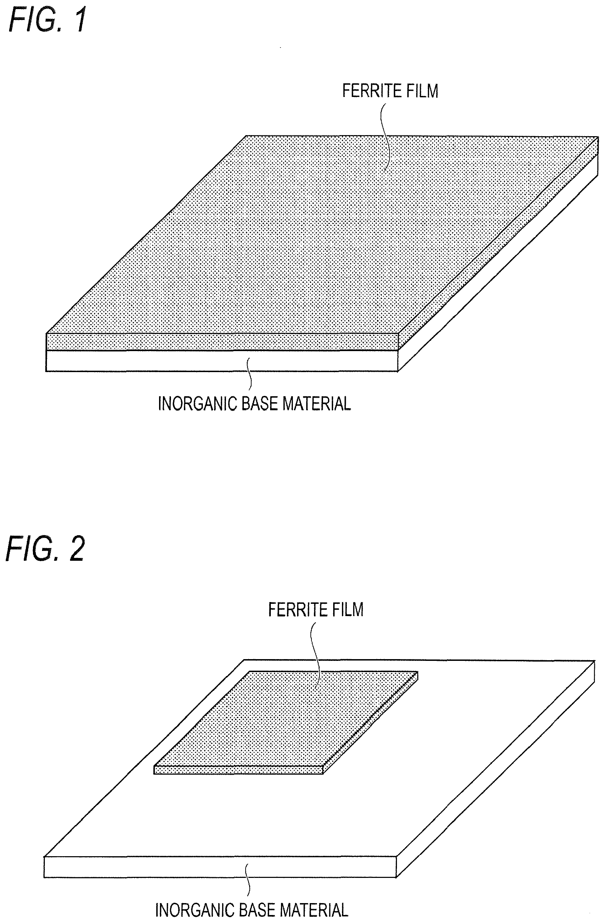

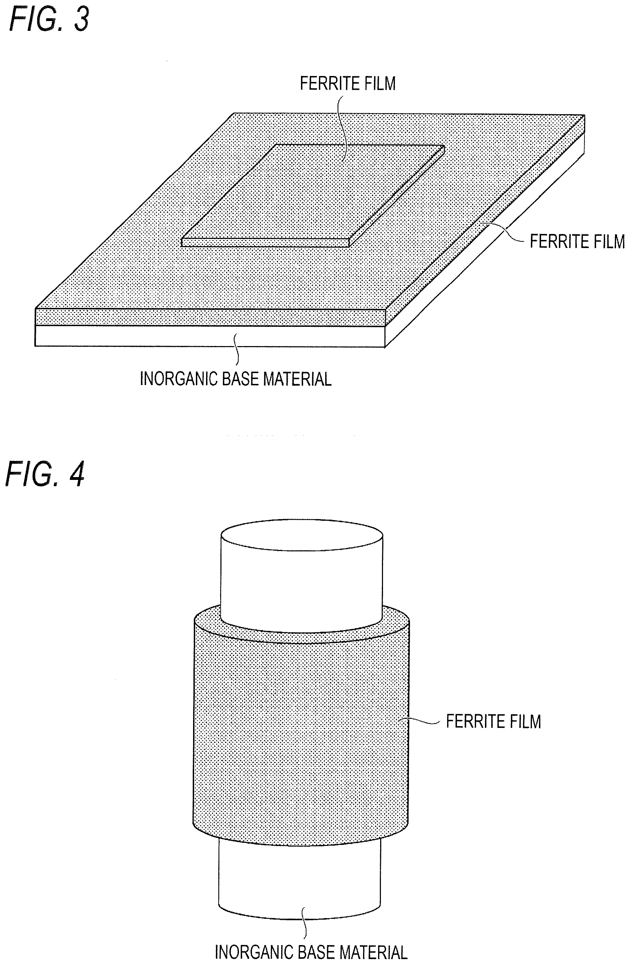

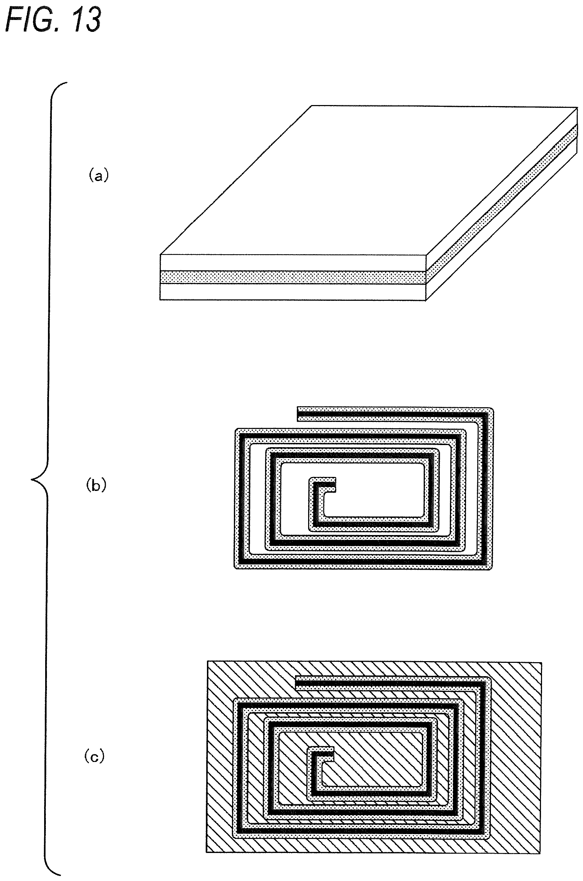

A form of the magnetic composite is also not particularly limited. As illustrated in Fig. 1, the ferrite layer (ferrite film) may be provided on the entire surface of the metal base material. As illustrated in Fig. 2, the ferrite layer may be provided only on a part of the surface of the metal base material. The ferrite layer may be provided not only on one surface of the metal base material but also on both surfaces thereof. As illustrated in Fig. 3, a ferrite layer having a partially changed thickness may be provided on the surface of the metal base material. Further, as illustrated in Fig. 4, the ferrite layer may be wound around an outer periphery of a rod-shaped metal base material.

The magnetic composite can be applied to various applications. Examples of such applications include an element or component having a coil and/or an inductor function, an electronic device, an electronic component accommodation housing, an electromagnetic wave absorber, an electromagnetic wave shield, or an element or component having an antenna function, which includes the magnetic composite.

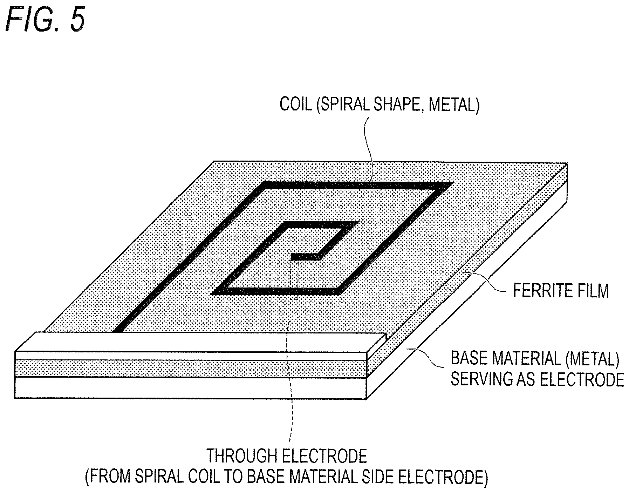

Fig. 5 illustrates an example in which the magnetic composite is applied to an inductor. The magnetic composite includes a metal base material, a ferrite layer (ferrite film) provided on one surface of the metal base material, and a coil provided on a surface of the ferrite layer. The metal base material constituted of a conductive material can function as a back electrode. The coil is constituted of a conductive material such as metal, and has a circuit pattern of a spiral shape. Therefore, an inductor function is exhibited. The circuit pattern of the coil may be formed by a method such as electroless plating, screen printing using a paste containing colloidal metal particles, ink jet, sputtering, or vapor deposition. By forming the circuit pattern on the ferrite layer, an element having a mild inductor function can be obtained.

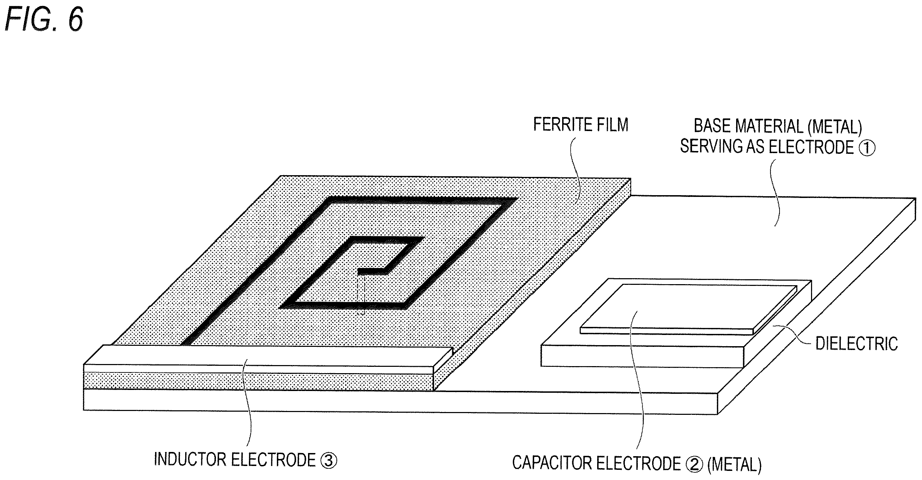

Fig. 6 illustrates an example in which the magnetic composite is applied to an LC filter. The magnetic composite includes a metal base material constituted of a conductive material, a ferrite layer (ferrite film) provided on a part of a surface of the metal base material, and a coil provided on a surface of the ferrite layer. In addition, a dielectric and a capacitor electrode provided on a surface of the dielectric are provided in a position of the metal base material where the ferrite layer is not provided. A portion where the ferrite layer is provided functions as an inductor element, while a portion where the dielectric is provided functions as a capacitor element. The metal base material constituted of a conductive material can function as a common electrode of the inductor element and the capacitor element, and can be operated as the LC filter as a whole.

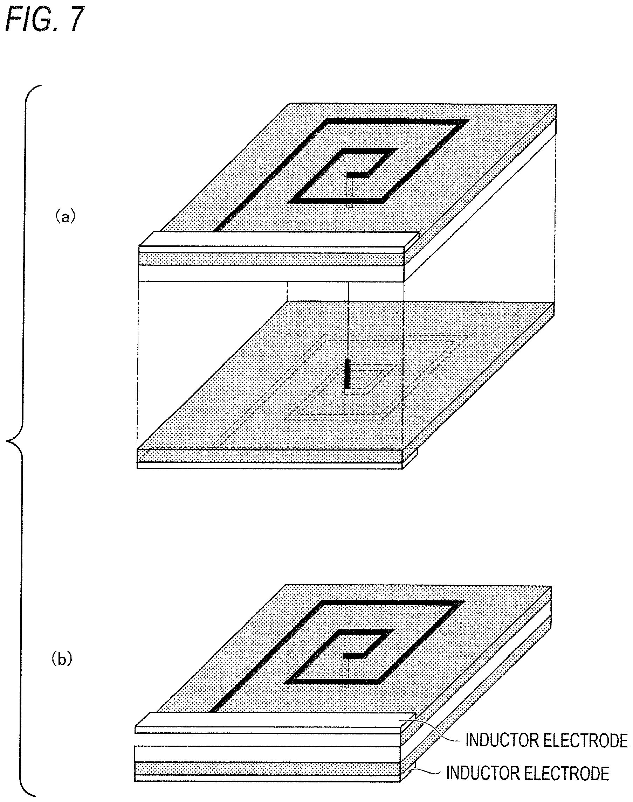

Fig. 7 illustrates another example in which the magnetic composite is applied to an inductor. In this example, ferrite layers (ferrite films) and coils are provided on both surfaces of the metal base material. The coil on a surface side and the coil on a back surface side are electrically connected to each other through a via hole (connection electrode) provided in the metal base material and the ferrite layers. By imparting an inductor function to both surfaces of the metal base material, it is possible to prepare a miniaturized inductor.

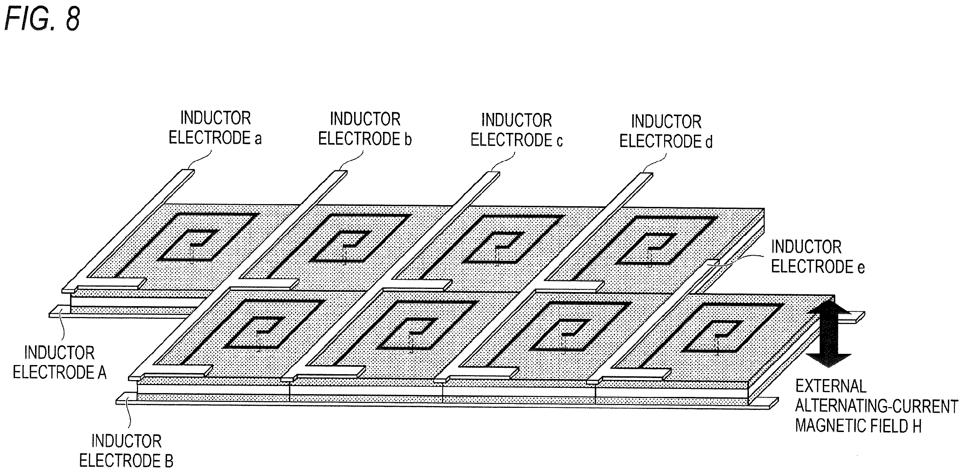

Fig. 8 illustrates an example in which the magnetic composite is applied to a magnetic sensor. In this example, inductor elements each having a ferrite layer (ferrite film) and a coil are arranged in an array on both surfaces of a metal base material. During operation of the magnetic sensor, in a state where an external alternating-current magnetic field is applied, regarding lateral inductor electrodes A, B, ··· (lateral direction) disposed on a back surface of the base material and longitudinal inductor electrodes a, b, c, ··· disposed on a surface of the base material, generated voltages are sequentially measured for each combination thereof. In a case where no magnetic material is present in the vicinity of the coil, inductances indicated by an inductor on the surface and an inductor on the back surface of the base material are the same, so that no voltage is generated. In a case where a magnetic material is present, inductances of inductors in the vicinity of the magnetic material change, so that a voltage is generated. A position of the magnetic material can be detected based on a combination of the inductors in which the voltage is generated.

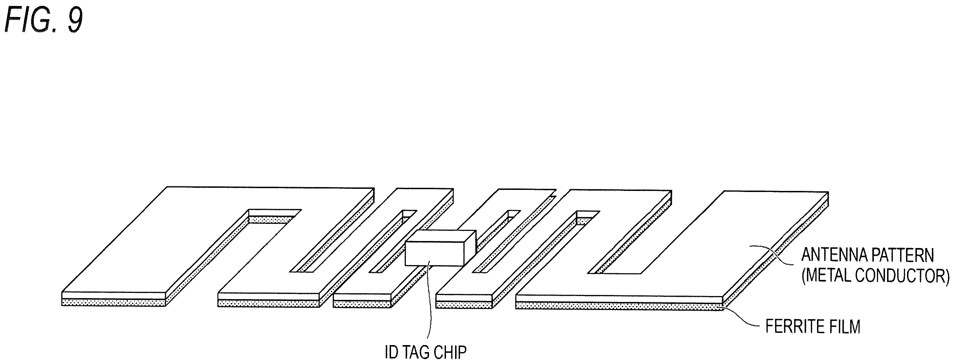

Fig. 9 illustrates an example in which the magnetic composite is applied to an antenna element (UHF-ID tag). The antenna element (magnetic composite) includes a metal base material formed in an antenna pattern, a ferrite layer (ferrite film) provided on a back surface of the metal base material, and an ID tag chip provided on a surface of the metal base material. Since the ferrite layer has higher permeability than a surrounding space, electromagnetic waves are likely to be collected in the ferrite layer. Antenna sensitivity can be improved by providing the antenna pattern on the ferrite layer.

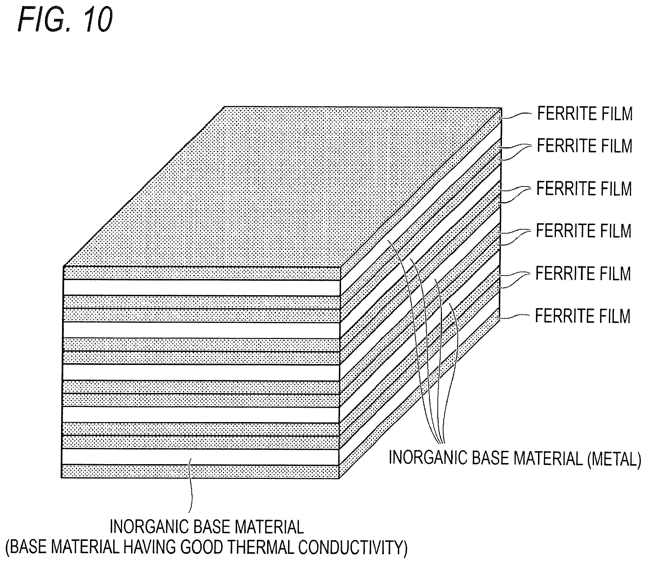

Fig. 10 illustrates an example in which the magnetic composite is applied to an electromagnetic wave absorber. The electromagnetic wave absorber (magnetic composite) has a structure in which metal base materials and ferrite layers (ferrite films) provided on surfaces of the metal base materials are alternately laminated. In addition, a base material having excellent thermal conductivity is provided on the lowermost surface thereof.

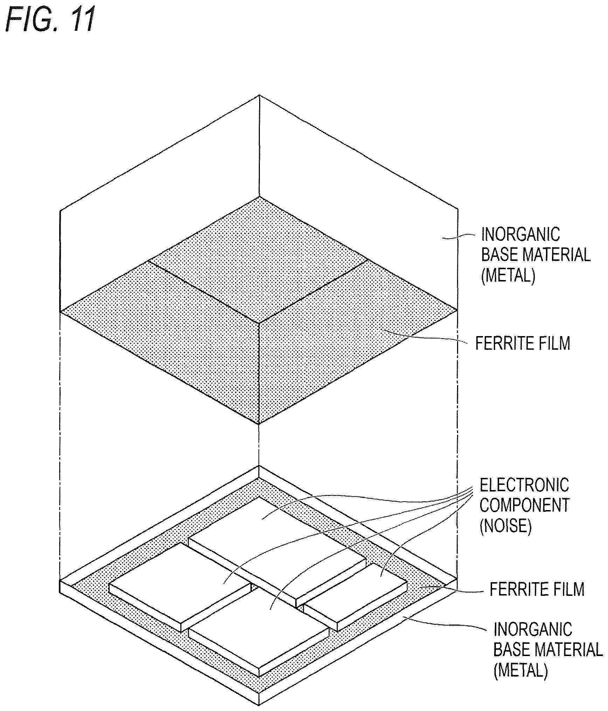

Fig. 11 illustrates an example in which the magnetic composite is applied to an electronic component accommodation housing. In this example, a ferrite layer (ferrite film) is provided on a surface of a metal base material, and electronic components are mounted thereon. In addition, a ferrite layer is also provided on an inner surface side of a metal base material serving as a lid portion of the housing. By providing a ferrite layer having an electromagnetic wave shielding effect on the housing, it is possible to prevent unnecessary electromagnetic waves emitted from the electronic components from leaking to a surrounding environment.

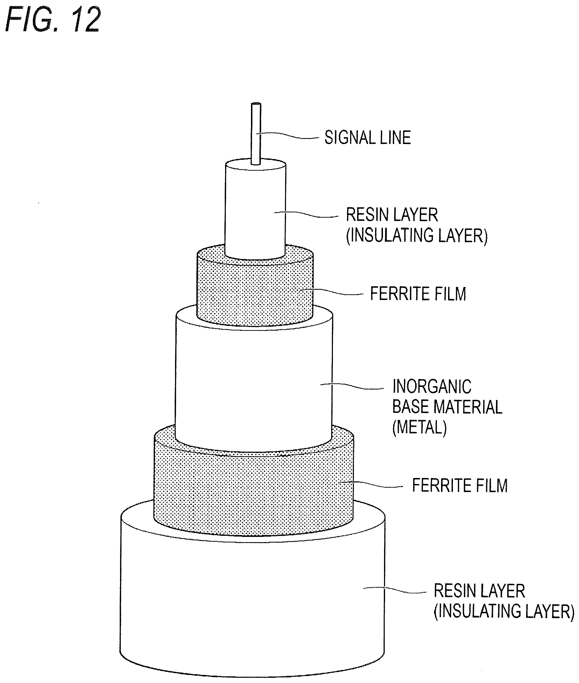

Fig. 12 illustrates an example in which the magnetic composite is used for a signal cable. In this example, ferrite layers (ferrite films) are provided on an outer surface and an inner surface of a tubular metal base material, and a signal line coated with a resin layer (insulating layer) is disposed inside the tubular metal base material. When a high-frequency signal is applied to the signal line, a leakage electromagnetic wave is radiated to the surroundings. By providing the ferrite layers, the leakage electromagnetic wave can be prevented from being radiated to the surroundings.

Fig. 13 illustrates an example in which the magnetic composite is applied to a winding-type inductor. In this example, (a) ferrite layers (ferrite films) are provided on both surfaces of a flexible metal base material. Then, by rolling the metal base material from an end such that the ferrite layer provided on one surface side is disposed inside, (b) a winding-type inductor (air-core) can be prepared. Further, (c) when an air-core portion is filled with a paste containing a magnetic filler, a winding-type inductor including a magnetic core is obtained. Since a part of the metal base material is not in direct contact with other parts due to the ferrite layer, it is possible not only to ensure insulation property, but also to obtain an effect of preventing a leakage flux due to the presence of the ferrite layer between winding wires.

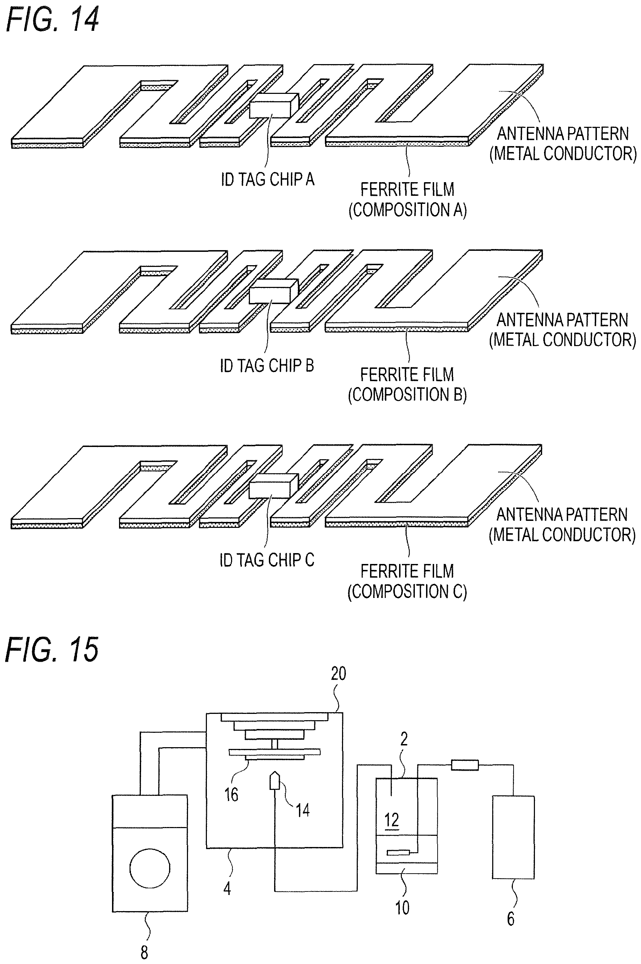

Fig. 14 illustrates an example in which the magnetic composite is applied to a temperature sensor. The temperature sensor (magnetic composite) includes a plurality of antenna elements each including a metal base material formed in an antenna pattern, a ferrite layer (ferrite film) provided on a back surface of the metal base material, and an ID tag chip provided on a surface of the metal base material. In addition, the ferrite layers provided in the respective antenna elements have different compositions. By constructing the temperature sensor with such a configuration, it is possible to measure a temperature in a noncontact manner with respect to an object in an environment where a reading wire cannot be provided, for example, in a vacuum or in a gas environment other than air. In addition, by using a combination of a plurality of ID tags backed by the ferrite layers having different compositions, it is possible to accurately measure the temperature by using a difference in frequency characteristics and a difference in temperature characteristics. Since the metal base material is used, it is possible to measure a temperature region that cannot be measured when using a resin.

«2. Manufacturing Method for Magnetic Composite»

A manufacturing method for the magnetic composite of the present embodiment is not limited as long as the above-described requirements are satisfied. However, a preferable manufacturing method includes the following processes; a process (preparation process) of preparing a metal base material and a spinel-type ferrite powder having an average particle diameter (D50) of 2.5 μm or more and 10.0 μm or less; and a process (film forming process) of forming a film of the ferrite powder on a surface of the metal base material by an aerosol deposition method.

As described above, a relatively thick ferrite layer can be prepared at a high film forming rate by forming the film by the aerosol deposition method (AD method) using ferrite powder having a specific particle diameter as a raw material. The ferrite layer is dense, has excellent magnetic properties, electrical properties, and heat resistance, and is excellent in adhesion to the base material. Therefore, the manufacturing method for the magnetic composite is suitable. Each process will be described in detail below.

<Preparation Process>

In the preparation process, the metal base material and the spinel-type ferrite powder are prepared. Details of the metal base material are as described above. On the other hand, as the spinel-type ferrite powder, power having an average particle diameter (D50) of 1.0 μm or more and 10.0 μm or less is prepared. The average particle diameter is preferably 2.5 μm or more and 7.0 μm or less. By adjusting the average particle diameter within the above-mentioned range, a dense ferrite layer having high adhesion can be obtained in the subsequent film forming process.

A method for preparing the ferrite powder is not limited. However, it is preferable that a ferrite raw material mixture is subjected to sintering in an atmosphere having an oxygen concentration lower than that of the air to prepare a sintered product, and the obtained sintered product is pulverized to prepare particles having a specific particle diameter and an irregular shape. Before the sintering, the ferrite raw material mixture may be subjected to calcination, pulverization, and/or granulation treatment. As a ferrite raw material, a known ferrite raw material such as an oxide, a carbonate, and a hydroxide may be used.

A shape of the ferrite powder is preferably an irregular shape. Specifically, an average value of a shape factor (SF-2) of the ferrite powder is preferably 1.02 or more and 1.50 or less, more preferably 1.02 or more and 1.35 or less, and still more preferably 1.02 or more and 1.25 or less. Here, SF-2 is an index indicating a degree of irregularity of the particles, and the closer SF-2 is to 1, the more spherical the shape is, and the larger SF-2 is, the more irregular the shape is. When SF-2 is excessively small, the particles are excessively rounded. Therefore, biting of the particles to the base material becomes worse, and the film forming rate cannot be increased. On the other hand, when SF-2 is excessively large, unevenness of a particle surface becomes excessively large. Therefore, although the film forming rate is high, voids tend to remain in the obtained ferrite layer due to the unevenness of the particle surface. When SF-2 is within the above-mentioned range, a dense ferrite layer can be obtained at a high film forming rate. SF-2 is determined according to the following formula (1).

$$SF\text{-}2 = \left( \left( \frac{(\text{PROJECTED PERIPHERAL LENGTH OF PARTICLE})^2}{(\text{PROJECTED AREA OF PARTICLE})} \right) \div 4\pi \right)$$

$$\cdots (1)$$

An average value of an aspect ratio of the ferrite powder is preferably 1.00 or more and 2.00 or less, more preferably 1.02 or more and 1.50 or less, and still more preferably 1.02 or more and 1.25 or less. When the aspect ratio is within the above-mentioned range, a gas flow for supplying the raw material is stabilized during film formation. On the other hand, when the aspect ratio exceeds the above-mentioned range, the raw material is easily clogged in a pipe from a raw material supply container to a nozzle. Therefore, the film forming rate may become unstable with the elapse of a film forming time. The aspect ratio is obtained according to the following formula (2).

$$\text{ASPECT RATIO} = \frac{\text{MAJOR AXIS FERET DIAMETER}}{\text{MINOR AXIS FERET DIAMETER}} \cdots (2)$$

Further, a CV value of the particle diameter of the ferrite powder is preferably 0.5 or more and 2.5 or less. Here, the CV value indicates a degree of variation in the particle diameter of the particles in the powder, and the CV value decreases as the particle diameter becomes more uniform, and increases as the particle diameter becomes more non-uniform. In a common pulverization method (bead mill, jet mill, or the like) for obtaining irregular particles, it is difficult to obtain powder having a CV value of less than 0.5. On the other hand, powder having a CV value of more than 2.5 is easily clogged in the pipe from the raw material supply container to the nozzle. Therefore, the film forming rate may become unstable with the elapse of a film forming time. The CV value is obtained according to the following formula (3) using a 10% cumulative diameter (D10), a 50% cumulative diameter (D50; average particle diameter), and a 90% cumulative diameter (D90) in volume particle size distribution.

$$\text{CV VALUE} = \frac{\text{D90} - \text{D10}}{\text{D50}} \cdots (3)$$

In a case where the calcination is performed at the time of preparing the ferrite powder, for example, the calcination may be performed under a condition of 500°C to 1,100°C × 1 hour to 24 hours in an air atmosphere. The sintering may be performed, for example, under a condition of 800°C to 1,350°C × 4 hours to 24 hours in an atmosphere such as the air or a reducing atmosphere. In addition, the oxygen concentration at the time of the sintering is preferably low. As a result, a lattice defect can be intentionally generated in a spinel crystal of the ferrite powder. When the lattice defect is contained in the crystal, plastic deformation tends to occur from the lattice defect as a starting point when the raw material grains collide with the base material in the subsequent film forming process. Therefore, a dense ferrite layer having high adhesion can be easily obtained. The oxygen concentration is preferably 0.001 vol% to 10 vol%, more preferably 0.001 vol% to 5 vol%, and still more preferably 0.001 vol% to 2 vol%. Further, when the ferrite has a composition containing copper (Cu), it is preferable to perform the sintering under a reducing atmosphere. When the sintering is performed in a reducing atmosphere, copper oxide (II) (CuO) releases a part of oxygen atoms and changes to copper oxide (I) (CuzO). In this case, a lattice defect is easily generated. In addition, making the ferrite powder to have an iron (Fe)-rich composition is also effective for obtaining a dense ferrite layer.

Pulverization of the sintered product is preferably performed using a pulverizer such as a dry bead mill. By performing dry pulverization, the sintered product is subjected to a mechanochemical treatment, the crystallite diameter is reduced, and surface activity is increased. Pulverized powder having high surface activity contributes to densification of the ferrite layer obtained in the subsequent film forming process, along with an effect of an appropriate particle diameter. The crystallite diameter (CSp) of the ferrite powder is preferably 2 nm or more and 100 nm or less. The crystallite diameter is more preferably 2 nm or more and 50 nm or less, and still more preferably 4 nm or more and 25 nm or less. By using ferrite powder having a fine crystallite diameter, a dense ferrite layer can be obtained.

<Film Forming Process>

In the film forming process (deposition process), the ferrite powder is formed into a film on the surface of the metal base material by the aerosol deposition method. The aerosol deposition method (AD method) is a method in which aerosolized raw material fine particles are injected onto a substrate at a high speed to form a coating film by a room temperature impact solidification phenomenon. Since the room temperature impact solidification phenomenon is utilized, a dense film having high adhesion can be formed. In addition, since the fine particles are used as a supply raw material, a thick film can be obtained at a high film forming rate as compared with the thin film forming method such as a sputtering method or a vapor deposition method in which the raw material is separated to an atomic level. Further, since the film can be formed at room temperature, it is not necessary to complicate a configuration of a device, and an effect of reducing manufacturing cost can also be obtained.

Fig. 15 illustrates an example of a configuration of an aerosol deposition film forming device. An aerosol deposition film forming device (20) includes an aerosolization chamber (2), a film formation chamber (4), a conveying gas source (6), and a vacuum evacuation system (8). The aerosolization chamber (2) includes a vibrator (10) and a raw material container (12) disposed thereon. A nozzle (14) and a stage (16) are provided inside the film formation chamber (4). The stage (16) is implemented to be movable perpendicularly to an injection direction of the nozzle (14).

In the film formation, a conveying gas is introduced from the conveying gas source (6) into the raw material container (12), and the vibrator (10) is caused to operate. Raw material fine particles (ferrite powder) are charged into the raw material container (12). The raw material fine particles are mixed with the conveying gas by vibration and subjected to aerosolization. In addition, the film formation chamber (4) is evacuated by the vacuum evacuation system (8) to depressurize the chamber. The aerosolized raw material fine particles are conveyed into the film formation chamber (4) by a pressure difference, and are injected from the nozzle (14). The injected raw material fine particles collide with a surface of a substrate (base material) placed on the stage (16) and are deposited thereon. In this case, in the raw material fine particles accelerated by gas conveyance, kinetic energy is locally released at the time of collision with the substrate, and bonding between the substrate and the particles and bonding between the particles are realized. Therefore, a dense film can be formed. By moving the stage (16) during the film formation, it is possible to form a coating film having a spread in a plane direction.

The reason why a dense ferrite layer can be obtained by the manufacturing method of the present embodiment is presumed as follows. Thus, it is said that ceramic is usually a material having a high elastic limit and being hardly plastically deformed. However, it is considered that when the raw material fine particles collide with the substrate at a high speed during the film formation by an aerosol deposition method, an impact force is large to exceed the elastic limit, and thus the fine particles are plastically deformed. Specifically, defects such as crystal plane deviation and dislocation movement occur inside the fine particles, and in order to compensate for the defects, plastic deformation occurs and a crystal structure becomes fine. In addition, a newly generated surface is formed and movement of substances occurs. As a result of a combined effect of the above, it is considered that bonding forces between the substrate and the particles and between the particles are increased, and a dense film can be obtained. Further, it is considered that a part of ferrite is decomposed and reoxidized during the plastic deformation, and $\alpha$-$Fe_2O_3$ contributing to an increase in resistance is generated. In addition, it is also presumed that the fine particles colliding with the metal base material as a substrate in an initial stage of the film formation penetrate into the base material, and the penetrated fine particles develop an anchor effect, thereby increasing the adhesion between the ferrite layer and the base material.

In order to obtain a dense ferrite layer, the average particle diameter of the raw material ferrite powder is important. In the present embodiment, the average particle diameter (D50) of the ferrite powder is preferably 1.0 $\mu$m or more and 10.0 $\mu$m or less. When the average particle diameter is less than 1.0 $\mu$m, it is difficult to obtain a dense film. This is because powder having a small average particle diameter has a small mass of particles constituting the powder. The aerosolized raw material fine particles collide with the substrate at a high speed together with the conveying gas. The conveying gas colliding with the substrate changes its direction and flows as an exhaust gas. Particles having a small particle diameter and a small mass are washed away by an exhaust flow of the conveying gas, and a collision speed with the surface of the substrate and an impact force caused by the collision are reduced. When the impact force is small, the plastic deformation of the fine particles becomes insufficient, and the crystallite diameter is not reduced. The formed film does not become dense and becomes a compact in which the powder is only compressed. Such a compact includes a large number of voids therein, and is inferior in magnetic properties and electrical properties. In addition, the adhesion to the base material does not increase. On the other hand, when the average particle diameter is excessively large exceeding 10.0 $\mu$m, the impact force received by one particle is large, but the number of contact points between particles is reduced. Therefore, the plastic deformation and packing are insufficient, and it is difficult to obtain a dense film.

Film forming conditions according to the aerosol deposition method are not particularly limited as long as a dense ferrite layer having high adhesion can be obtained. Air or an inert gas (nitrogen, argon, helium, or the like) can be used as the conveying gas. In particular, air that is easy to handle is preferable. A flow rate of the conveying gas may be, for example, 1.0 L/min to 20.0 L/min. In addition, an internal pressure of the film formation chamber may be, for example, 10 Pa to 50 Pa before the film formation and 50 Pa to 400 Pa in the middle of the film formation. A scanning speed (moving speed) of the metal base material (stage) may be, for example, 1.0 mm/s to 10.0 mm/s. Coating (film formation) may be performed only once or may be performed a plurality of times. In particular, from a viewpoint of sufficiently ensuring the thickness of the ferrite layer to be obtained, it is preferable to perform the coating a plurality of times. The number of times of coating is, for example, 5 times or more and 100 times or less.

The ratio (LCf/LCp) of the lattice constant (LCf) of the spinel phase contained in the ferrite layer to the lattice constant (LCp) of the spinel phase contained in the raw material ferrite powder is preferably 0.95 or more and 1.05 or less ($0.95 \leq$ LCf/LCp $\leq 1.05$). The spinel phase in the raw material ferrite powder has an oxygen-deficient composition and has lattice defects. Therefore, the lattice constant is larger than that in a state where no lattice defect exists. On the other hand, when the raw material ferrite powder is subjected to an aerosol deposition film forming treatment, plastic deformation from the lattice defects as a starting point occurs. In addition, an active surface is generated due to the plastic deformation, and the active surface is oxidized. Since reconstruction of the crystal structure and reoxidation of the active surface occur, the lattice constant changes. By controlling the lattice constant ratio (LCf/LCp) within the above-mentioned range, an amount of $\alpha$-$Fe_2O_3$ accompanying the reconstruction of the crystal structure and the reoxidation of the active surface can be adjusted within a desired range, and as a result, a ferrite layer having excellent electrical properties (electric insulation) can be formed while maintaining excellent magnetic properties. The lattice constant ratio (LCf/LCp) is more preferably 0.99 or more and 1.04 or less.

A degree of change in the lattice constant varies depending on manufacturing conditions and a composition of the raw material ferrite powder as well as a material and a type of the base material. Specifically, when a ferrite composition is a stoichiometric composition or an iron (Fe)-rich composition ($M_xFe_{3-x}O_4$: $0 \leq x \leq 1$, and M is a metal atom), an amount of oxygen contained in the raw material ferrite powder is likely to be substantially smaller than a stoichiometric ratio, depending on sintering conditions thereof. Therefore, the lattice constant of the raw material ferrite powder tends to increase. On the other hand, in the ferrite layer formed by the AD method, the crystal structure is reconstructed by oxidation accompanying the plastic deformation of the raw material grains, and thus the lattice constant tends to be smaller than that of the raw material ferrite powder. In particular, this tendency is remarkable in a case where ferrite powder containing lithium (Li) or manganese (Mn) or ferrite powder sintered at a lower oxygen concentration than the air is used. Therefore, in this case, LCf/LCp is likely to be less than 1.00.

When an amount of Fe is smaller than the stoichiometric ratio of the ferrite ($M_xFe_{3-x}O_4$: $1 < x$, and M is a metal atom), the amount of oxygen contained in the ferrite is about the same as the stoichiometric ratio. In addition, in the ferrite layer formed by AD method, lattice defects due to the plastic deformation increase, and thus the lattice constant is likely to increase. In particular, this tendency is remarkable in a case where ferrite powder containing Cu or ferrite powder sintered in the air atmosphere is used. Therefore, in this case, LCf/LCp tends to exceed 1.00.

In a case where the base material contains copper (Cu) or silver (Ag), LCf/LCp is likely to be small. This is because Cu and Ag are less likely to oxidize than ferrite particles and tend to give oxygen to the ferrite film. In this case, LCf/LCp is likely to be less than 1.00. On the other hand, in a case where the base material contains iron (Fe) or nickel (Ni), LCf/LCp is likely to be large, and Fe or Ni is more easily oxidized than the ferrite particles and tends to take oxygen from the ferrite film. In this case, LCf/LCp is likely to exceed 1.00.

The lattice constant ratio (LCf/LCp) can also be adjusted by controlling conditions of the aerosol deposition film formation. Thus, progress of strain and reoxidation can be promoted by increasing the collision speed of the raw material fine particles. The collision speed of the raw material fine particles can be changed by adjusting the internal pressure of the chamber or the like. In addition, excessive progress of reoxidation can be prevented by changing the film forming rate. This is because the reoxidation proceeds from the surface of the raw material fine particles, and thus the progress of the reoxidation is prevented when the film forming rate of the ferrite layer is increased to shorten an exposure time of the raw material fine particles to the air.

A ratio (CSf/CSp) of a crystallite diameter (CSf) of the spinel phase contained in the ferrite layer to a crystallite diameter (CSp) of the spinel phase contained in the raw material ferrite powder is preferably 0.01 or more and 0.50 or less ($0.01 \leq CSf/CSp \leq 0.50$). The crystallite diameter of the ferrite changes through the aerosol deposition film formation. This is because strain occurs at the time of collision with the base material, and the active surface is reoxidized. Even when the film formation is performed under a condition that the crystallite diameter ratio (CSf/CSp) becomes excessively small, a dense ferrite layer having high adhesion cannot be obtained. This is because the internal stress of the ferrite layer becomes too large. In addition, even when the film formation could be performed, the ferrite layer is easily peeled off due to the internal stress. Therefore, stability over time is insufficient. The crystallite diameter ratio (CSf/CSp) is more preferably 0.05 or more and 0.30 or less, and still more preferably 0.10 or more and 0.20 or less.

In this way, the magnetic composite of the present embodiment can be obtained. In the obtained magnetic composite, since the ferrite layer is dense, the magnetic properties and the electrical properties (electric insulation) thereof are excellent. In addition, the adhesion to the metal base material is high. Actually, the present inventors succeeded in preparing a magnetic composite including a ferrite layer having a relative density of 0.95 or more and adhesion of 9H in pencil hardness. Further, the ferrite layer has relatively small magnetic loss in a high-frequency region. In addition, although not limited, by using a thinned metal base material, flexibility can be imparted to the magnetic composite, and a device having a complicated shape can be prepared. The magnetic composite including such a ferrite layer can be used not only for an electromagnetic wave absorber but also for an application of an electronic component such as a transformer, an inductance element and an impedance element, and is particularly suitable for a UHF tag, a 5G filter and a high-frequency inductor.

A technique for preparing such a magnetic composite of the present embodiment has not been known so far as the inventors know. For example, the composite material containing the ferrite powder proposed in Patent Literature 1 is inferior in magnetic properties because the composite material contains a large amount of resin that is nonmagnetic. In addition, regarding the ferrite thin film proposed in Patent Literature 2, it is difficult to form the ferrite thin film to be thick in view of manufacture. Further, regarding the composite magnetic material proposed in Patent Literature 3, since a highly conductive metal magnetic material is contained, the composite magnetic material cannot be applied to applications requiring electric insulation. The magnetic composite of the present embodiment is sufficiently applicable to applications in which a ferrite layer does not contain a resin or a metal component and electric insulation is required.

Patent Literature 3 also discloses that the composite magnetic film is prepared by setting a content of iron powder (metal magnetic material) to 0% (paragraph [0048] in Patent Literature 3). However, a peak of the (222) plane is present in the X-ray diffraction profile (Fig. 3 in Patent Literature 3), and it is presumed that the ferrite layer in the magnetic film is not in a microcrystalline state and is inferior in denseness and adhesion. Patent Literature 3 discloses $\alpha$-$Fe_2O_3$ as a ferrite raw material together with Ni-Zn ferrite and Mn-Zn ferrite (paragraph [0036] in Patent Literature 3). However, Patent Literature 3 does not teach that a predetermined amount of $\alpha$-$Fe_2O_3$ is contained in the ferrite layer, and that by containing $\alpha$-$Fe_2O_3$, a conductive path in the ferrite layer is cut off and the electric resistance increases. Actually, when $\alpha$-$Fe_2O_3$ is used as the raw material, coarse $\alpha$-$Fe_2O_3$ is contained in the ferrite layer, and this coarse $\alpha$-$Fe_2O_3$ prevents the magnetic domain wall displacement of a ferrite component, resulting in deterioration of the magnetic properties.

EXAMPLES

The present invention will be described in more detail using the following examples. However, the present invention is not limited to the following examples.

(1) Preparation of Magnetic Composite

[Example 1]

In Example 1, ferrite powder containing Mn-Zn ferrite as a principal component was prepared, and the obtained ferrite powder was formed into a film on each of a front surface and a back surface of a copper (Cu) foil (metal base material) having a thickness of 30 $\mu$m to prepare a magnetic composite. Preparation of the ferrite powder and film formation were performed by the following procedures.

<Preparation of Ferrite Powder>

As raw materials, iron oxide ($Fe_2O_3$), trimanganese tetraoxide ($Mn_3O_4$), and zinc oxide (ZnO) were used, and the raw materials were weighed and mixed such that a molar ratio of $Fe_2O_3$ : $Mn_3O_4$ : ZnO = 53 : 12.3 : 10. The mixing was performed using a Henschel mixer. The obtained mixture was molded using a roller compactor to obtain a granulated product (temporary granulated product).

Next, the granulated raw material mixture (temporary granulated product) was calcined to prepare a calcined product. The calcination was performed using a rotary kiln under a condition of 880°C × 2 hours in an air atmosphere.

Thereafter, the obtained calcined product was pulverized and granulated to prepare a granulated product. First, the calcined product was coarsely pulverized using a dry bead mill (steel beads of $\varphi$3/16 inches), and then water was added thereto, followed by fine pulverization using a wet bead mill (zirconia beads of (p0.65 mm) to obtain a slurry. A solid content concentration of the obtained slurry was 50 mass%, and a particle diameter (slurry particle diameter) of the pulverized powder was 2.15 $\mu$m. To the obtained slurry, a polycarboxylic acid ammonium salt was added as a dispersant at a ratio of 50 cc with respect to 25 kg of a solid content in the slurry, and a 10 mass% aqueous solution of polyvinyl alcohol (PVA) was added as a binder at an addition amount of 500 cc. Thereafter, the slurry to which the dispersant and the binder were added was granulated using a spray dryer to obtain the granulated product.

Then, the obtained granulated product was sintered under a condition of 1,250°C × 4 hours in a non-oxidizing atmosphere using an electric furnace to prepare a sintered product. Next, the obtained sintered product was pulverized using the dry bead mill (steel beads of (p3/16 inches) to obtain a pulverized sintered product.

<Film Formation>

A film formation of a ferrite layer was performed on each of a front surface and a back surface of a metal base material using the obtained pulverized sintered product. The copper (Cu) foil having a thickness of 30 $\mu$m was used as the metal base material. The film formation was performed according to the aerosol deposition (AD) method under the following conditions. Further, the film formation was performed 30 times on each of the front surface and the back surface of the metal base material.

- Carrier gas (conveying gas): air
- Gas flow rate: 2.5 L/min
- Internal pressure of film formation chamber (before film formation): 30 Pa

- Internal pressure of film formation chamber (during film formation): 100 Pa
- Substrate scanning speed: 5 mm/sec
- Number of times of coating: 30 times + 30 times
- Distance from base material to nozzle: 20 mm
- Nozzle shape: 10 mm $\times$ 0.4 mm
- Film shape: sheet shape

[Example 2]

In Example 2, a film formation of a ferrite layer was performed only on a surface (one surface) of a metal base material (Cu foil), and the number of times of coating was changed to 15 times. A magnetic composite was prepared in the same manner as in Example 1 except for the above.

[Example 3]

In Example 3, the number of times of coating at the time of the filing formation was changed to 40 times. A magnetic composite was prepared in the same manner as in Example 2 except for the above.

[Example 4]

In Example 4, a laminate obtained by vapor-depositing aluminum (Al) having a thickness of 0.05 $\mu$m on a PET film having a thickness of 100 $\mu$m was used as a metal base material, and a ferrite layer was formed on a vapor deposition surface of the laminate. A magnetic composite was prepared in the same manner as in Example 3 except for the above.

[Example 5]

In Example 5, an aluminum (Al) foil having a thickness of 30 $\mu$m was used as a metal base material. A magnetic composite was prepared in the same manner as in Example 3 except for the above.

[Example 6]

In Example 6, a nickel (Ni) foil having a thickness of 30 $\mu$m was used as a metal base material. A magnetic composite was prepared in the same manner as in Example 3 except for the above.

[Example 7]

In Example 7, at the time of preparing ferrite powder, raw materials were weighed and mixed such that a molar ratio of $Fe_2O_3$ : $Mn_3O_4$ : ZnO = 51.5 : 9.3 : 20.5. A magnetic composite was prepared in the same manner as in Example 1 except for the above.

[Example 8]

In Example 8, at the time of preparing ferrite powder, raw materials were weighed and mixed such that a molar ratio of $Fe_2O_3$ : $Mn_3O_4$ : ZnO = 52 : 8 : 24. A magnetic composite was prepared in the same manner as in Example 1 except for the above.

[Example 9]

In Example 9, raw material powder (ferrite powder) containing Ni-Cu-Zn ferrite as a principal component was prepared, and then the obtained ferrite powder was formed into a film on each of a front surface and a back surface of a copper (Cu) foil (metal base material) having a thickness of 30 $\mu$m to prepare a magnetic composite. Preparation of the ferrite powder and film formation were performed by the following procedures.
As raw materials, iron oxide ($Fe_2O_3$), zinc oxide (ZnO), nickel oxide (NiO), and copper oxide (CuO) were used, and the raw materials were weighed and mixed such that a molar ratio of $Fe_2O_3$ : ZnO : NiO : CuO = 48.5 : 29.25 : 16 : 6.25. In addition, calcination was performed under a condition of 850°C $\times$ 2 hours in an air atmosphere, and sintering was performed under a condition of 1,100°C $\times$ 4 hours in an oxidizing atmosphere. A magnetic composite was prepared in the same manner as in Example 1 except for the above.

[Example 10]

In Example 10, at the time of preparing ferrite powder, raw materials were weighed and mixed such that a molar ratio of $Fe_2O_3$ : ZnO : NiO : CuO = 48.5 : 33 : 12.5 : 6. In addition, calcination was performed under a condition of 910°C $\times$ 2 hours in an air atmosphere. Further, an amount of a binder to be added was set to 250 cc to obtain a granulated product. A magnetic composite was prepared in the same manner as in Example 9 except for the above.

[Example 11]

In Example 11, a film formation of a ferrite layer was performed only on a surface (one surface) of a copper (Cu) foil (metal base material), and the number of times of coating was changed to 15 times. A magnetic composite was prepared in the same manner as in Example 10 except for the above.

[Example 12]

In Example 12, raw material powder (ferrite powder) containing Ni-Zn ferrite as a principal component was prepared, and then the obtained ferrite powder was formed into a film on each of a front surface and a back surface of a copper (Cu) foil (metal base material) having a thickness of 30 $\mu$m to prepare a magnetic composite. Preparation of the ferrite powder and film formation were performed by the following procedures.
As raw materials, iron oxide ($Fe_2O_3$), zinc oxide (ZnO), and nickel oxide (NiO) were used, and the raw materials were weighed and mixed such that a molar ratio of $Fe_2O_3$ : ZnO: NiO = 48 : 32.5 : 19.5. In addition, calcination was performed under a condition of 950°C $\times$ 2 hours in an air atmosphere, and sintering was performed under a condition of 1,250°C $\times$ 4 hours in an oxidizing atmosphere. A magnetic composite was prepared in the same manner as in Example 1 except for the above.

[Example 13]

In Example 13, raw material powder (ferrite powder) containing Mn-Mg ferrite as a principal component was prepared, and then the obtained ferrite powder was formed into a film on each of a front surface and a back surface of a copper (Cu) foil (metal base material) having a thickness of 30 $\mu$m to prepare a magnetic composite. Preparation of the ferrite powder and film formation were performed by the following procedures.
As raw materials, iron oxide ($Fe_2O_3$), trimanganese tetraoxide ($Mn_3O_4$), and magnesium oxide (MgO) were used, and the raw materials were weighed and mixed such that a molar ratio of $Fe_2O_3$ : $Mn_3O_4$: MgO = 50.1 : 13.3 : 10. In addition, calcination was performed under a condition of 920°C $\times$ 2 hours in an air atmosphere, and sintering was performed under a condition of 1,180°C $\times$ 4 hours in a non-oxidizing atmosphere. A magnetic composite was prepared in the same manner as in Example 1 except for the above.

[Example 14]

In Example 14, raw material powder (ferrite powder) containing Mn ferrite as a principal component was prepared, and then the obtained ferrite powder was formed into a film on each of a front surface and a back surface of a copper (Cu) foil (metal base material) having a thickness of 30 $\mu$m to prepare a magnetic composite. Preparation of the ferrite powder and film formation were performed by the following procedures.
As raw materials, iron oxide ($Fe_2O_3$) and trimanganese tetraoxide ($Mn_3O_4$) were used, and the raw materials were weighed and mixed such that a molar ratio of FejOj : $Mn_3O_4$ = 80 : 6.67. In addition, calcination was performed under a condition of 900°C $\times$ 2 hours in an air atmosphere, and a sintering temperature was performed under a condition of 1,300°C $\times$ 4 hours in a non-oxidizing atmosphere. A magnetic composite was prepared in the same manner as in Example 1 except for the above.

[Example 15]

In Example 15, raw material powder (ferrite powder) containing Zn ferrite as a principal component was prepared, and then the obtained ferrite powder was formed into a film on each of a front surface and a back surface of a copper (Cu) foil (metal base material) having a thickness of 30 $\mu$m to prepare a magnetic composite. Preparation of the ferrite powder and film formation were performed by the following procedures.
As raw materials, iron oxide ($Fe_2O_3$) and zinc oxide (ZnO) were used, and the raw materials were weighed and mixed such that a molar ratio of $Fe_2O_3$ : ZnO = 80.7 : 19.3. In this case, carbon (carbon black) was added at a ratio of 1 mass% with respect to a total amount of $Fe_2O_3$ and ZnO. In addition, calcination was performed under a condition of 1,000°C × 2 hours in a non-oxidizing atmosphere, an amount of a binder to be added was set to 1,000 cc to obtain a granulated product, and sintering was performed under a condition of 1,300°C × 4 hours in a non-oxidizing atmosphere. Further, the film formation was performed 20 times on each of the front surface and the back surface of the metal base material. A magnetic composite was prepared in the same manner as in Example 1 except for the above.

[Example 16]

In Example 16, raw material powder (ferrite powder) containing Zn ferrite as a principal component was prepared, and then the obtained ferrite powder was formed into a film on a copper (Cu) foil (metal base material) having a thickness of 30 μm to prepare a magnetic composite. Preparation of the ferrite powder and film formation were performed by the following procedures.

As raw materials, iron oxide (FeiOs) and zinc oxide (ZnO) were used, and the raw materials were weighed and mixed such that a molar ratio of $Fe_2O_3$ : ZnO = 85.7 : 14.3. In this case, carbon (carbon black) was added at a ratio of 1.2 mass% with respect to a total amount of $Fe_2O_3$ and ZnO. A magnetic composite was prepared in the same manner as in Example 15 except for the above.

[Example 17 (Comparative Example)]

In Example 17, a film of a ferrite layer was formed only on a surface (one surface) of a copper (Cu) foil (metal base material), and the number of times of coating was changed to once. A magnetic composite was prepared in the same manner as in Example 1 except for the above.

[Example 18 (Comparative Example)]

In Example 18, a ferrite layer was prepared by a coating method. Specifically, ferrite powder was prepared in the same manner as in Example 1, and 50 parts by mass of the obtained ferrite powder was dispersed and mixed with 50 parts by mass of a photocurable resin. Thereafter, the obtained mixture was applied onto a PET film. The coating was performed using an applicator such that a coating film having a thickness of 12 μm was obtained. Next, the obtained coating film was cured with ultraviolet to form a film, and the film peeled from the PET film was used as a magnetic sheet.

[Example 19 (Comparative Example)]

In Example 19, a ferrite layer was prepared by a coating method. Specifically, ferrite powder was prepared in the same manner as in Example 9, and 50 parts by mass of the obtained ferrite powder was dispersed and mixed with 50 parts by weight of a photocurable resin. Thereafter, the obtained mixture was applied onto a PET film. The coating was performed using an applicator such that a coating film having a thickness of 12 μm was obtained. Next, the obtained coating film was cured with ultraviolet to form a film, and the film peeled from the PET film was used as a magnetic sheet.

For Examples 1 to 19, manufacturing conditions of the ferrite powder and the magnetic composite are summarized in Table 1 and Table 2.

Table 1 Manufacture conditions for ferrite powder

| | Charged composition | | | | | | | Calcination | | Granulation | | | | Sintering | | Post-proc-ess |
|---|---|---|---|---|---|---|---|---|---|---|---|---|---|---|---|---|
| | Fe$_2$O$_3$ (mol) | Mn$_3$O$_4$ (mol) | MgO (mol) | ZnO (mol) | NiO (mol) | CuO (mol) | Amount of carbon (C) (mass%) | Tempera-ture (°C) | Atmos-phere | Slurry particle diameter ($\mu$m) | Amount of bind-er (cc) | Amount of disper-sant (cc) | Slurry con-centration (mass%) | Tempera-ture (°C) | Atmos-phere | |
| Example 1 | 53 | 12.3 | - | 10 | - | - | - | 880 | Air | 2.15 | 500 | 50 | 50 | 1,250 | Non-oxidiz-ing | Crushing + pulveriza-tion |
| Example 2 | 53 | 12.3 | - | 10 | - | - | - | 880 | Air | 2.15 | 500 | 50 | 50 | 1,250 | Non-oxidiz-ing | Crushing + pulveriza-tion |
| Example 3 | 53 | 12.3 | - | 10 | - | - | - | 880 | Air | 2.15 | 500 | 50 | 50 | 1,250 | Non-oxidiz-ing | Crushing + pulveriza-tion |
| Example 4 | 53 | 12.3 | - | 10 | - | - | - | 880 | Air | 2.15 | 500 | 50 | 50 | 1,250 | Non-oxidiz-ing | Crushing + pulveriza-tion |
| Example 5 | 53 | 12.3 | - | 10 | - | - | - | 880 | Air | 2.15 | 500 | 50 | 50 | 1,250 | Non-oxidiz-ing | Crushing + pulveriza-tion |
| Example 6 | 53 | 12.3 | - | 10 | - | - | - | 880 | Air | 2.15 | 500 | 50 | 50 | 1,250 | Non-oxidiz-ing | Crushing + pulveriza-tion |
| Example 7 | 51.5 | 9.3 | - | 20.5 | - | - | - | 880 | Air | 2.22 | 500 | 50 | 50 | 1,250 | Non-oxidiz-ing | Crushing + pulveriza-tion |
| Example 8 | 52 | 8 | - | 24 | - | - | - | 880 | Air | 2.42 | 500 | 50 | 50 | 1,250 | Non-oxidiz-ing | Crushing + pulveriza-tion |
| Example 9 | 48.5 | - | - | 29.25 | 16 | 6.25 | - | 850 | Air | 2.56 | 500 | 50 | 50 | 1,100 | Oxidizing | Crushing + pulveriza-tion |

(continued)

| | Charged composition | | | | | | | Calcination | | Granulation | | | | Sintering | | Post-process |
|---|---|---|---|---|---|---|---|---|---|---|---|---|---|---|---|---|
| | $Fe_2O_3$ (mol) | $Mn_3O_4$ (mol) | MgO (mol) | ZnO (mol) | NiO (mol) | CuO (mol) | Amount of carbon (C) (mass%) | Temperature (°C) | Atmosphere | Slurry particle diameter (μm) | Amount of binder (cc) | Amount of dispersant (cc) | Slurry concentration (mass%) | Temperature (°C) | Atmosphere | |
| Example 10 | 48.5 | - | - | 33 | 12.5 | 6 | - | 910 | Air | 2.77 | 250 | 50 | 50 | 1,100 | Oxidizing | Crushing + pulverization |
| Example 11 | 48.5 | - | - | 33 | 12.5 | 6 | - | 910 | Air | 2.77 | 250 | 50 | 50 | 1,100 | Oxidizing | Crushing + pulverization |
| Example 12 | 48 | - | - | 32.5 | 19.5 | - | - | 950 | Air | 2.61 | 500 | 50 | 50 | 1,250 | Oxidizing | Crushing + pulverization |
| Example 13 | 50.1 | 13.3 | 10 | - | - | - | - | 920 | Air | 2.13 | 500 | 50 | 50 | 1,180 | Non-oxidizing | Crushing + pulverization |
| Example 14 | 80 | 6.67 | - | - | - | - | - | 900 | Air | 2.34 | 500 | 50 | 50 | 1,300 | Non-oxidizing | Crushing + pulverization |
| Example 15 | 80.7 | - | - | 19.3 | - | - | 1 | 1,000 | Non-oxidizing | 2.45 | 1,000 | 50 | 50 | 1,300 | Non-oxidizing | Crushing + pulverization |
| Example 16 | 85.7 | - | - | 14.3 | - | - | 1.2 | 1,000 | Non-oxidizing | 2.52 | 1,000 | 50 | 50 | 1,300 | Non-oxidizing | Crushing + pulverization |
| Example 17* | 53 | 12.3 | - | 10 | - | - | - | 880 | Air | 2.15 | 500 | 50 | 50 | 1,250 | Non-oxidizing | Crushing + pulverization |
| Example 18* | 53 | 12.3 | - | 10 | - | - | - | 880 | Air | 2.15 | 500 | 50 | 50 | 1,250 | Non-oxidizing | Crushing + pulverization |

| | Charged composition | | | | | | | Calcination | | Granulation | | | | Sintering | | Post-process |
|---|---|---|---|---|---|---|---|---|---|---|---|---|---|---|---|---|
| | Fe$_2$O$_3$ (mol) | Mn$_3$O$_4$ (mol) | MgO (mol) | ZnO (mol) | NiO (mol) | CuO (mol) | Amount of carbon (C) (mass%) | Temperature (°C) | Atmosphere | Slurry particle diameter (μm) | Amount of binder (cc) | Amount of dispersant (cc) | Slurry concentration (mass%) | Temperature (°C) | Atmosphere | |
| Example 19* | 48.5 | - | - | 29.25 | 16 | 6.25 | - | 850 | Air | 2.56 | 500 | 50 | 50 | 1,100 | Oxidizing | Crushing + |
| Note 1) "*" indicates a comparative example. | | | | | | | | | | | | | | | | |

Table 2 Manufacture conditions for magnetic composite

| | Aerosol deposition film formation | | | | | | |
| | Carrier gas | Gas flow rate (L/min) | Internal pressure of film formation chamber (Pa) | | Substrate scanning speed (mm/sec) | Number of times of coating | |
| | | | Before film formation | During film formation | | Surface | Back surface |
|---|---|---|---|---|---|---|---|
| Example 1 | Air | 2.5 | 30 | 100 | 5 | 30 | 30 |
| Example 2 | Air | 2.5 | 30 | 100 | 5 | 15 | - |
| Example 3 | Air | 2.5 | 30 | 100 | 5 | 40 | - |
| Example 4 | Air | 2.5 | 30 | 100 | 5 | 40 | - |
| Example 5 | Air | 2.5 | 30 | 100 | 5 | 40 | - |
| Example 6 | Air | 2.5 | 30 | 100 | 5 | 40 | - |
| Example 7 | Air | 2.5 | 30 | 100 | 5 | 30 | 30 |
| Example 8 | Air | 2.5 | 30 | 100 | 5 | 30 | 30 |
| Example 9 | Air | 2.5 | 30 | 100 | 5 | 30 | 30 |
| Example 10 | Air | 2.5 | 30 | 100 | 5 | 30 | 30 |
| Example 11 | Air | 2.5 | 30 | 100 | 5 | 15 | - |
| Example 12 | Air | 2.5 | 30 | 100 | 5 | 30 | 30 |
| Example 13 | Air | 2.5 | 30 | 100 | 5 | 30 | 30 |
| Example 14 | Air | 2.5 | 30 | 100 | 5 | 30 | 30 |
| Example 15 | Air | 2.5 | 30 | 100 | 5 | 20 | 20 |
| Example 16 | Air | 2.5 | 30 | 100 | 5 | 20 | 20 |
| Example 17* | Air | 2.5 | 30 | 100 | 5 | 1 | - |
| Example 18* | - | - | - | - | - | - | - |
| Example 19* | - | - | - | - | - | - | - |
| Note 1) "*" indicates a comparative example. | | | | | | | |

(2) Evaluation

Evaluations on various properties of the ferrite powder, the metal base material, and the magnetic composite in Examples 1 to 19 were made as follows.

<Particle Shape (Raw Material Powder)>

An average value of SF-2 and an average value of the aspect ratio of the ferrite powder were determined as follows. The ferrite powder was analyzed by using a particle image analyzer (Morphologi G3, manufactured by Spectris Pic.), and a projected peripheral length, a projected area, a major axis Feret diameter, and a minor axis Feret diameter were determined for 30,000 particles. The analysis was performed using an objective lens with a magnification of 20 times. Then, obtained data was used to calculate SF-2 and the aspect ratio for each particle according to the following formulae (1) and (2), and average values thereof were obtained.

$$SF-2 = \left( \left( \frac{(PROJECTED\ PERIPHERAL\ LENGTH\ OF\ PARTICLE)^2}{(PROJECTED\ AREA\ OF\ PARTICLE)} \right) \div 4\pi \right)$$

$$\cdots (1)$$

$$ASPECT\ RATIO = \frac{MAJOR\ AXIS\ FERET\ DIAMETER}{MINOR\ AXIS\ FERET\ DIAMETER} \cdots (2)$$

<Particle Size Distribution (Raw Material Powder)>

The particle size distribution of the ferrite powder was measured as follows. First, 0.1 g of a sample and 20 ml of water were placed in a 30 ml beaker, and two drops of sodium hexametaphosphate were added as a dispersant. Next, the mixture was dispersed using an ultrasonic homogenizer (model UH-150, manufactured by SMT Co., Ltd.). In this case, an output level of the ultrasonic homogenizer was set to 4, and dispersion was performed for 20 seconds. Thereafter, bubbles generated on a surface of the beaker were removed, and the beaker was introduced into a laser diffraction type particle size distribution measuring device (SALD-7500nano, manufactured by Shimadzu Corporation) to perform the measurement. In this measurement, a 10% cumulative diameter (D10), a 50% cumulative diameter (D50; average particle diameter), and a 90% cumulative diameter (D90) in the volume particle size distribution were obtained. Measurement conditions were set to a pump speed of 7, an internal ultrasonic irradiation time of 30, and a refractive index of 1.70-050i. Then, D10, D50, and D90 were used to calculate a CV value according to the following formula (3).

$$CV\ VALUE = \frac{D90 - D10}{D50} \cdots (3)$$

<XRD (Raw Material Powder and Ferrite Layer)>

The ferrite powder and the ferrite layer of the magnetic composite were analyzed by an X-ray diffraction (XRD) method. Analysis conditions were as follows.

- X-ray diffraction device: X'pertMPD (including a high-speed detector) manufactured by PANalytical
- Radiation source: Co-K$\alpha$
- Tube voltage: 45 kV
- Tube current: 40 mA
- Scanning speed: 0.002°/s (continuous scanning)
- Scanning range (2$\theta$): 15° to 90°

In an obtained X-ray diffraction profile, an integrated intensity ($I_{222}$) of a (222) plane diffraction peak of a spinel phase and an integrated intensity ($I_{311}$) of a (311) plane diffraction peak were obtained, and an XRD peak intensity ratio ($I_{222}/I_{311}$) was calculated. In addition, based on the X-ray diffraction profile, respective content ratios of the spinel phase and $\alpha$-Fe$_2$O$_3$ were obtained.

Further, the X-ray diffraction profile was subjected to Rietveld analysis to estimate lattice constants (LCp and LCf) of the spinel phase, and crystallite diameters (CSp and CSf) of the spinel phase were obtained according to Sclierrer's formula. Then, a lattice constant change rate (LCf/LCp) and a crystallite diameter change rate (CSf/CSp) of the spinel phase before and after the film formation were calculated.

<Magnetic Properties (Raw Material Powder, Metal Base material, and Magnetic Composite)>

The magnetic properties (saturation magnetization, residual magnetization, and coercivity) of the ferrite powder, the metal base material, and the magnetic composite were measured as follows. First, the sample was packed in a cell having an inner diameter of 5 mm and a height of 2 mm, and set in a sample vibrating type magnetic measurement device (VSM-C7-10A, manufactured by Toei Industry Co., Ltd.). An applied magnetic field was applied and swept to 5 kOe, and then the applied magnetic field was decreased to draw a hysteresis curve. Based on data of the obtained curve, the saturation magnetization (σs), the residual magnetization (σr), and the coercivity (Hc) of the sample were obtained.

<True Specific Gravity (Raw Material Powder)>

The true specific gravity of the raw material powder was measured by a gas substitution method in accordance with JIS Z8837:2018.

<Thickness and Element Distribution (Ferrite Layer)>

A cross section of the ferrite layer was observed using a field emission type scanning electron microscope (FE-SEM) to determine the thickness. Then, element mapping analysis for the cross section was performed using an energy dispersive X-ray spectrometer (EDX) attached to the microscope, and a mapping image was obtained.

<Density (Ferrite Layer)>

The density of the ferrite layer was measured as follows. First, a mass of a metal base material alone before the film of the ferrite layer was formed was measured. Next, a mass of the metal base material after the film of the ferrite layer was formed was measured, and a difference from the mass of the metal base material alone was calculated to obtain a mass of the ferrite layer. In addition, a film formation area and a thickness of the ferrite layer were measured. The thickness was determined by observing the cross section of the ferrite layer with a scanning electron microscope (SEM). Then, the density of the ferrite layer was calculated according to the following formula (4).

$$\text{DENSITY OF FERRITE LAYER} \left( g/cm^3 \right)$$
$$= \frac{\text{MASS OF FERRITE LAYER} (g)}{\text{FILM FORMATION AREA OF FERRITE LAYER} \left( cm^2 \right) \times \text{THICKNESS} (cm)}$$
$$\cdots (4)$$

<Surface Roughness (Ferrite Layer)>

An arithmetic mean roughness (Ra) and a maximum height (Rz) of the surface of the ferrite layer were evaluated using a laser microscope (OPTELICS HYBRID, manufactured by Lasertec Corporation). For each sample, measurement was performed at 10 points, and an average value thereof was obtained. The measurement was performed in accordance with JIS B 0601-2001. In addition, a roughness ratio ($Ra/d_F$) was calculated based on the arithmetic mean roughness (Ra) and the thickness ($d_F$) of the ferrite layer.

<Surface Resistance (Ferrite Layer)>

The surface resistance of the ferrite layer was measured using a resistivity meter (LorestaHP MCP-T410, manufactured by Mitsubishi Chemical Corporation).

<Permeability (Magnetic Composite)>

The permeability of the magnetic composite was measured by a microstripline complex permeability measuring method using a vector network analyzer (PNA N5222B, 10 MHz to 26.5 GHz, manufactured by Keysight) and a permeability measuring device (manufactured by KEYCOM Corporation). Specifically, the magnetic composite was cut out and was set in the permeability measuring device as a measurement sample. In this case, a sheet-shaped sample was cut into a length of 16 mm and a width of 5 mm. In addition, in a case where a toroidal sample was used, a shape of the sample was made to satisfy an outer diameter of 6.75 mm and an inner diameter of 3.05 mm. Next, a measurement frequency was swept on a logarithmic scale in a range of 100 MHz to 10 GHz. A real part $\mu'$ and an imaginary part $\mu''$ of complex permeability at a frequency of 1 GHz were determined, and a loss factor ($\tan\delta$) was calculated according to the following formula (5).

$$t \, a \, n \, \delta \; = \; \frac{\mu''}{\mu'} \quad \cdots \quad (5)$$

<Bendability (Magnetic Composite)>

The magnetic composite was wound around an inch tube to evaluate the bendability. Specifically, three types of inch tubes respectively having an outer diameter of 1/16 inches, an outer diameter of 1/8 inches, and an outer diameter of 1/4 inches were prepared, and the magnetic composite was wound around each of the inch tubes such that the ferrite layer was on an outer side. Then, a state of the ferrite layer was visually observed, and rated as o to × according to the following criteria.

　　∘: No change was observed in the ferrite layer before and after winding.
　　Δ: Cracks occurred in the ferrite layer after winding.
　　×: The ferrite layer was peeled off after winding.

<Adhesion (Magnetic Composite)>

The adhesion between the ferrite layer and the metal base material was evaluated by a pencil hardness test (pencil scratch test). The measurement was performed in accordance with old JIS K5400. In each test, scratching with a pencil having the same concentration mark was repeated five times. In this case, a tip of a pencil lead was polished every time the pencil was scratched. Pencil hardness increases in the order of 3B, 2B, B, HB, F, H, 2H, 3H, 4H, 5H, 6H, 7H, 8H, 9H, and 10H, and a higher hardness means better adhesion.

<Curie Point (Magnetic Composite)>

The Curie point (Tc) of the magnetic composite was measured using a sample vibrating type magnetic measurement device (VSM). Specifically, a magnetic composite cut into a predetermined size (length: 8 mm, width: 6 mm) was placed in a measurement cell and set in the sample vibrating type magnetic measurement device (VSM-5 type, manufactured by Toei Industry Co., Ltd.). The sample was heated from room temperature to 500°C at a rate of 0.3°C/s in a state where a 10 kOe of applied magnetic field was applied, and the saturation magnetization during heating was measured. The Curie point was calculated based on a temperature dependence of the obtained saturation magnetization.

(3) Evaluation Results

For Examples 1 to 19, properties of the ferrite powder and properties of the metal base material are shown in Tables 3 and 4, respectively. In addition, properties of the magnetic composite are shown in Tables 5 and 6.
As shown in Table 3, in all of the ferrite powder used for the film formations in Examples 1 to 19, the content ratio of the spinel phase was as high as 90 mass% or more, and synthesis of the spinel-type ferrite sufficiently progressed. In addition, the XRD peak intensity ratio ($I_{222}/I_{311}$) was about 2.5% to 5%, which was comparable to that of a common spinel-type ferrite. Further, the average particle diameter (D50) was 3.6 $\mu$m to 5.2 $\mu$m, and the crystallite diameter was about 6 nm to 18 nm.
As shown in Table 4, the saturation magnetization ($\sigma$s) of the metal base material (Ni foil) of Example 6 which was a ferromagnetic material was as high as 56.6 emu/g, whereas the saturation magnetization of the metal base materials (Cu foil and Al foil) of Examples 1 to 5 and 7 to 17 which were paramagnetic materials was almost zero.
As shown in Tables 5 and 6, in the magnetic composites of Examples 1 to 16, the thickness (dF) of the ferrite layer was relatively large as 3.5 $\mu$m or more, and the XRD peak intensity ratio ($I_{222}/I_{311}$) was zero (0). In addition, the amount of a-$Fe_2O_3$ was 0.5 mass% to 37.3 mass%, and the crystallite diameter was as small as 2.05 nm or less. Therefore, these samples had high relative density, adhesion, and surface resistance. In particular, in Examples 2 and 6, the relative density was very high as 0.96 to 0.97. In Examples 1, 2, and 6 to 16, the pencil hardness was as high as 9H or more, and results of adhesion tests were good. Further, in Examples 1, 2, 4 to 6, and 8 to 13, results of bendability tests were good. The pencil hardness in Examples 4 and 5 was slightly low. This is because aluminum having low strength was used as the base material.
On the other hand, in Example 17 in which the thickness ($d_F$) of the ferrite layer was as small as 0.6 $\mu$m, the crystallite diameter was large although the relative density was high. In addition, the film of the ferrite layer was not uniformly formed, resulting in a large roughness ratio ($Ra/d_F$) and poor surface smoothness, and as a result, an influence of the base material was large and the surface resistance was small. Further, in Example 17, a result was obtained in which the formed ferrite layer was thin, and uniformity of the ferrite layer was poor, so that the bendability was also poor.

In Examples 18 and 19 in which the preparation was performed by the coating method, it was found that the imaginary part ($\mu''$) of the complex permeability and $\tan\delta$ were large, and the magnetic loss was large. In addition, it was found that cracks were generated in the magnetic sheet due to generation of pinholes in the magnetic sheet, the bendability was poor, and the resin was decomposed at a temperature of more than 200°C, resulting in lack of temperature stability.

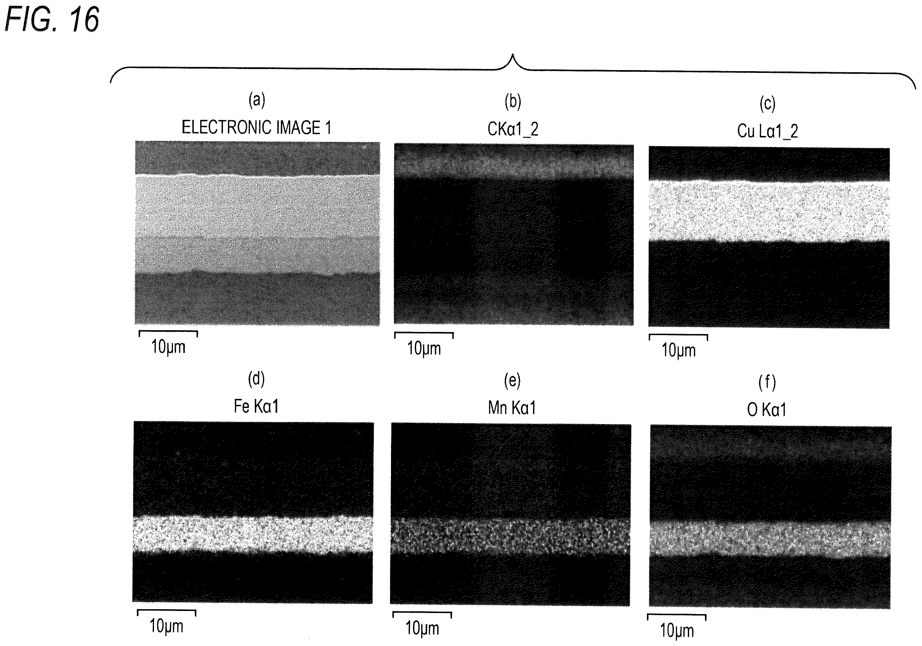

Cross-sectional element mapping images of the ferrite layer of the magnetic composite obtained in Example 2 are illustrated in (a) to (f) of Fig. 16. Here, (a) to (f) of Fig. 16 are an electron beam image (a), a carbon (C) mapping image (b), a copper (Cu) mapping image (c), an iron (Fe) mapping image (d), a manganese (Mn) mapping image (e), and an oxygen (O) mapping image (f), respectively. In addition, in (a) to (f) of Fig. 16, the metal base material (Cu foil) is illustrated on an upper side, and the ferrite layer (Mn-Zn ferrite layer) is illustrated on a lower side.

Component elements of the metal base material (Cu foil) and the ferrite layer (Mn-Zn ferrite layer) were clearly separated. Thus, copper (Cu) was present on a base material side, and manganese (Mn), iron (Fe), and oxygen (O) were present only on a ferrite layer side. Based on the above, it was found that diffusion of elements due to a reaction did not occur between the metal base material and the ferrite layer. In addition, carbon (C) was not confirmed in either of the metal base material and the ferrite layer.

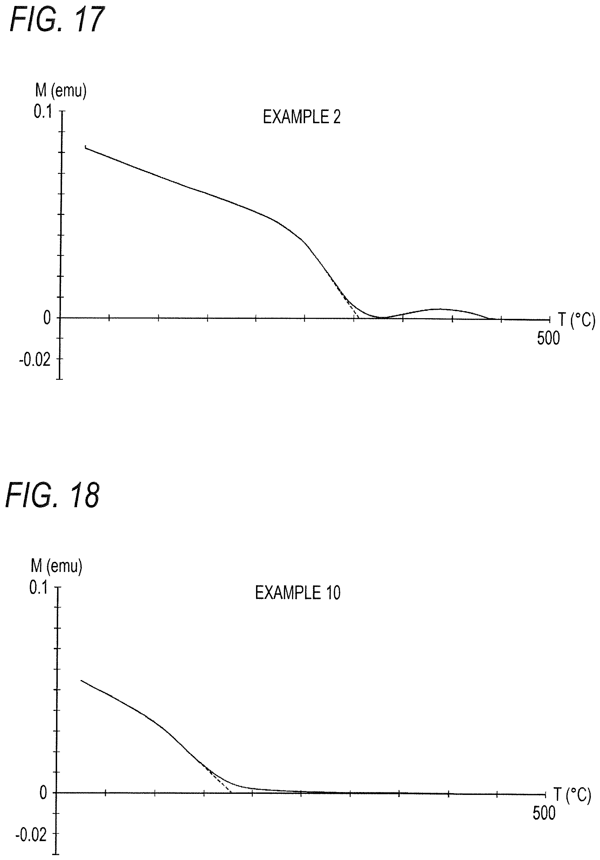

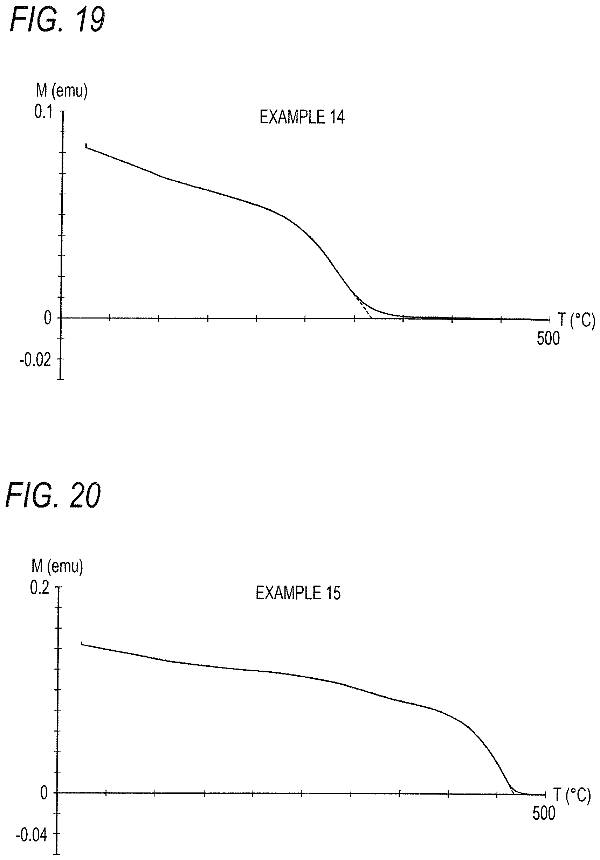

The temperature dependence of the saturation magnetization of the magnetic composite obtained in each of Examples 2, 10, 14, and 15 is illustrated in each of Figs. 17 to 20. In each sample, the saturation magnetization decreased as the temperature increased, and typical temperature characteristics of ferrite were exhibited. In addition, Curie points (Tc) were 310°C (Example 2), 180°C (Example 10), 320°C (Example 14), and 470°C (Example 15), respectively, and each indicated a value corresponding to a composition of the ferrite layer included in each sample.

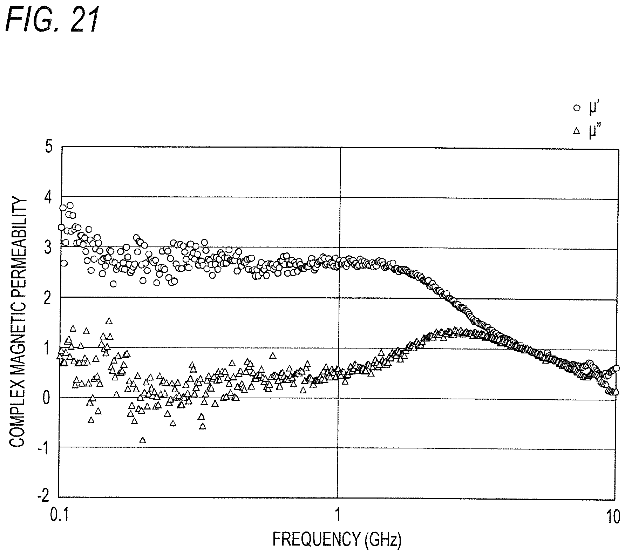

The permeability (real part $\mu'$ and imaginary part $\mu''$) of the magnetic composite obtained in Example 2 is illustrated in Fig. 21. From a low-frequency side over a high-frequency range of 1 GHz or more, it was found that $\mu''$ was substantially zero and $\mu'$ was a constant value, and $\mu''$ was a local maximum at a frequency of 1 GHz or more.

Based on these results, it was found that the magnetic composite of the present embodiment included a ferrite layer that was dense, had a relatively large thickness, and was excellent in various properties such as magnetic properties.

Table 3 Properties of ferrite powder

| | Ferrite powder | | | | | | | | | | | | | |
| | Particle size distribution | | | SF-2 | Aspect ratio | True specific gravity (g/cm³) | Crystal phase | | $I_{222}/I_{311}$ (%) | Lattice constant LCp (Å) | Crystallite diameter CSp (nm) | Magnetic properties (@5kOe) | | |
| | D10 (μm) | D50 (μm) | D90 (μm) | | | | Spinel phase (mass%) | Fe₂O₃ (mass%) | | | | σs (emu/g) | σr (emu/g) | Hc (Oe) |
|---|---|---|---|---|---|---|---|---|---|---|---|---|---|---|
| Example 1 | 1.4 | 5.0 | 10.2 | 1.16 | 1.49 | 5.15 | 99.4 | 0.6 | 4.19 | 8.4950 | 16.025 | 85.6 | 4.2 | 50.6 |
| Example 2 | 1.4 | 5.0 | 10.2 | 1.16 | 1.49 | 5.15 | 99.4 | 0.6 | 4.19 | 8.4950 | 16.025 | 85.6 | 4.2 | 50.6 |
| Example 3 | 1.4 | 5.0 | 10.2 | 1.16 | 1.49 | 5.15 | 99.4 | 0.6 | 4.19 | 8.4950 | 16.025 | 85.6 | 4.2 | 50.6 |
| Example 4 | 1.4 | 5.0 | 10.2 | 1.16 | 1.49 | 5.15 | 99.4 | 0.6 | 4.19 | 8.4950 | 16.025 | 85.6 | 4.2 | 50.6 |
| Example 5 | 1.4 | 5.0 | 10.2 | 1.16 | 1.49 | 5.15 | 99.4 | 0.6 | 4.19 | 8.4950 | 16.025 | 85.6 | 4.2 | 50.6 |
| Example 6 | 1.4 | 5.0 | 10.2 | 1.16 | 1.49 | 5.15 | 99.4 | 0.6 | 4.19 | 8.4950 | 16.025 | 85.6 | 4.2 | 50.6 |
| Example 7 | 1.1 | 4.2 | 10.6 | 1.16 | 1.52 | 5.32 | 99.3 | 0.7 | 3.78 | 8.4821 | 16.852 | 57.8 | 2.0 | 24.4 |
| Example 8 | 1.1 | 4.2 | 9.5 | 1.24 | 1.52 | 5.36 | 99.2 | 0.8 | 3.93 | 8.4776 | 16.428 | 69.2 | 3.1 | 39.2 |
| Example 9 | 0.8 | 4.1 | 11.0 | 1.14 | 1.67 | 5.47 | 99.7 | 0.3 | 4.67 | 8.4043 | 16.682 | 57.3 | 4.0 | 57.2 |
| Example 10 | 0.9 | 4.5 | 11.5 | 1.12 | 1.57 | 5.54 | 99.6 | 0.4 | 4.66 | 8.4104 | 17.724 | 50.8 | 3.0 | 43.1 |
| Example 11 | 0.9 | 4.5 | 11.5 | 1.12 | 1.57 | 5.54 | 99.6 | 0.4 | 4.66 | 8.4104 | 17.724 | 50.8 | 3.0 | 43.1 |
| Example 12 | 1.1 | 5.0 | 11.7 | 1.31 | 1.64 | 5.56 | 99.6 | 0.4 | 4.76 | 8.4028 | 16.508 | 59.5 | 4.1 | 57.9 |

(continued)

| | Ferrite powder | | | | | | | | | | | | |
|---|---|---|---|---|---|---|---|---|---|---|---|---|---|
| | Particle size distribution | | | SF-2 | Aspect ratio | True specific gravity (g/cm$^3$) | Crystal phase | | I$_{222}$/I$_{311}$ (%) | Lattice constant LCp (Å) | Crystallite diameter CSp (nm) | Magnetic properties (@5kOe) | | |
| | D10 ($\mu$m) | D50 ($\mu$m) | D90 ($\mu$m) | | | | Spinel phase (mass%) | Fe$_2$O$_3$ (mass%) | | | | as (emu/g) | $\sigma$r (emu/g) | Hc (Oe) |
| Example 13 | 1.3 | 3.6 | 9.0 | 1.21 | 1.53 | 5.07 | 99.4 | 0.6 | 3.82 | 8.4839 | 14.603 | 65.5 | 6.0 | 75.4 |
| Example 14 | 1.4 | 4.6 | 11.1 | 1.20 | 1.68 | 5.26 | 93.7 | 6.3 | 2.68 | 8.4333 | 6.078 | 79.1 | 16.5 | 236.1 |
| Example 15 | 1.6 | 5.2 | 11.8 | 1.11 | 1.71 | 5.40 | 99.6 | 0.4 | 3.40 | 8.4104 | 10.711 | 95.8 | 11.6 | 151.7 |
| Example 16 | 1.6 | 5.2 | 11.9 | 1.11 | 1.70 | 5.39 | 99.5 | 0.5 | 3.55 | 8.4127 | 11.187 | 94.8 | 10.7 | 142.9 |
| Example 17* | 1.4 | 5.0 | 10.2 | 1.16 | 1.49 | 5.15 | 99.4 | 0.6 | 4.19 | 8.4950 | 16.025 | 85.6 | 4.2 | 50.6 |
| Example 18* | 1.4 | 5.0 | 10.2 | 1.16 | 1.49 | 5.15 | 99.4 | 0.6 | 4.19 | 8.4950 | 16.025 | 85.6 | 4.2 | 50.6 |
| Example 19* | 0.8 | 4.1 | 11.0 | 1.14 | 1.67 | 5.47 | 99.7 | 0.3 | 4.67 | 8.4043 | 16.682 | 57.3 | 4.0 | 57.2 |
| Note 1) "*" indicates a comparative example. | | | | | | | | | | | | | | |

Table 4 Properties of metal base material

| | Inorganic base material | | | |
|---|---|---|---|---|
| | Material | Thickness $d_M$ ($\mu$m) | Magnetic properties | |
| | | | $\sigma s$ (emu/g) | or (emu/g) |
| Example 1 | Cu (metal) | 30 | 0.2 | 0.0 |
| Example 2 | Cu (metal) | 30 | 0.2 | 0.0 |
| Example 3 | Cu (metal) | 30 | 0.2 | 0.0 |
| Example 4 | Al (metal) | 0.05 | 0.2 | 0.0 |
| Example 5 | Al (metal) | 30 | 0.2 | 0.0 |
| Example 6 | Ni (metal) | 30 | 56.6 | 14.9 |
| Example 7 | Cu (metal) | 30 | 0.2 | 0.0 |
| Example 8 | Cu (metal) | 30 | 0.2 | 0.0 |
| Example 9 | Cu (metal) | 30 | 0.2 | 0.0 |
| Example 10 | Cu (metal) | 30 | 0.2 | 0.0 |
| Example 11 | Cu (metal) | 30 | 0.2 | 0.0 |
| Example 12 | Cu (metal) | 30 | 0.2 | 0.0 |
| Example 13 | Cu (metal) | 30 | 0.2 | 0.0 |
| Example 14 | Cu (metal) | 30 | 0.2 | 0.0 |
| Example 15 | Cu (metal) | 30 | 0.2 | 0.0 |
| Example 16 | Cu (metal) | 30 | 0.2 | 0.0 |
| Example 17* | Cu (metal) | 30 | 0.2 | 0.0 |
| Example 18* | - | - | - | - |
| Example 19* | - | - | - | - |
| Note 1) "*" indicates a comparative example. | | | | |

Table 5 Properties of magnetic composite

| | Ferrite layer | | | | | | | | | | | | | | | |
|---|---|---|---|---|---|---|---|---|---|---|---|---|---|---|---|---|
| | Thickness $d_F$ (μm) | Thickness division | | Thickness ratio | Density (g/cm$^3$) | Relative density | Ra (μm) | Rz (μm) | Ra/$d_F$ | Composition (mass%) | | $I_{222}/I_{311}$ (%) | Lattice constant LCf (Å) | Crystallite diameter CSf (nm) | Lattice constant change rate LCf/LCp | Crystallite diameter change rate CSf/CSp | Surface resistance (Ω) |
| | | Surface | Back surface | | | | | | | Spinel phase | Fe$_2$O$_3$ | | | | | | |
| Example 1 | 18.0 | 9.0 | 9.0 | 0.30 | 4.43 | 0.86 | 0.162 | 0.973 | 0.009 | 81.4 | 18.6 | 0.00 | 8.4960 | 1.9314 | 1.0001 | 0.121 | 1.0×10$^8$or more |
| Example 2 | 5.7 | 5.7 | - | 0.19 | 4.97 | 0.96 | 0.151 | 0.943 | 0.026 | 92.8 | 7.2 | 0.00 | 8.4776 | 1.8469 | 0.9980 | 0.115 | 1.0×10$^8$or more |
| Example 3 | 13.3 | 13.3 | - | 0.44 | 3.68 | 0.72 | 0.152 | 0.929 ......m. 9 | 0.011 | 90.1 | 9.9 | 0.00 | 8.3038 | 1.8926 | 0.9775 | 0.118 | 1.0×10$^8$or more |
| Example 4 | 5.7 | 5.7 | - | 114.00 | 3.85 | 0.75 | 0.123 | 0.882 | 0.022 | 90.4 | 9.6 | 0.00 | 8.4653 | 1.8706 | 0.9965 | 0.117 | 1.0×10$^8$or more |
| Example 5 | 4.7 | 4.7 | | 0.16 | 3.92 | 0.76 | 0.152 | 0.999 | 0.032 | 90.0 | 10.0 | 0.00 | 8.4529 | 1.8944 | 0.9950 | 0.118 | 1.0×10$^8$or more |
| Example 6 | 5.8 | 5.8 | | 0.19 | 4.98 | 0.97 | 0.137 | 0.921 | 0.024 | 92.3 | 7.7 | 0.00 | 8.7666 | 1.8836 | 1.0320 | 0.118 | 1.0×10$^8$or more |
| Example 7 | 20.0 | 10.0 | 10.0 | 0.33 | 4.21 | 0.81 | 0.143 | 0.961 | | 73.8 | 26.2 | 0.00 | 8.4827 | 1.9115 | 1.0001 | 0.113 | 1.0×10$^8$or more |
| Example 8 | 18.0 | 9.0 | 9.0 | 0.30 | 4.18 | 0.80 | 0.139 | 0.943 | 0.008 | 68.5 | 31.5 | 0.00 | 8.4880 | 1.8386 | 1.0012 | 0.112 | 1.0×10$^8$or more |
| Example 9 | 10.0 | 5.0 | 5.0 | 0.17 | 4.72 | 0.87 | 0.125 | 0.911 | 0.013 | 84.9 | 15.1 | 0.00 | 8.4742 | 1.9012 | 1.0083 | u.114 | 1.0×10$^8$or more |
| Example 10 | 15.0 | 7.5 | 7.5 | 0.25 | 4.63 | 0.86 | 0.122 | 0.897 | 0.008 | 79.4 | 20.6 | 0.00 | 8.4868 | 1.9398 | 1.0091 | 0.109 | 1.0×10$^8$or more |
| Example 11 | 3.5 | 3.5 | - | 0.12 | 3.72 | 0.67 | 0.128 | 0.796 | 0.037 | 99.5 | 0.5 | 0.00 | 8.3956 | 1.9074 | 0.9982 | 0.108 | 2.3×10$^7$ |
| Example 12 | 10.0 | 5.0 | 5.0 | 0.17 | 3.61 | 0.68 | 0.131 | 0.834 | 0.013 | 62.7 | 37.3 | 0.00 | 8.4737 | 1.8535 | 1.0084 | 0.112 | 1.0×10$^8$or more |

(continued)

| | Ferrite layer | | | | | | | | | | | | | | | |
|---|---|---|---|---|---|---|---|---|---|---|---|---|---|---|---|---|
| | Thickness $d_F$ (µm) | Thickness division | | Thickness ratio | Density (g/cm$^3$) | Relative density | Ra (µm) | Rz (µm) | Ra/$d_F$ | Composition (mass%) | | $I_{222}/I_{311}$ (%) | Lattice constant LCf (Å) | Crystallite diameter CSf (nm) | Lattice constant change rate LCf/LCp | Crystallite diameter change rate CSf/CSp | Surface resistance (Ω) |
| | | Surface | Back surface | | | | | | | Spinel phase | Fe$_2$O$_3$ | | | | | | |
| Example 13 Example | 12.0 | 6.0 | 6.0 | 0.20 | 3.96 | 0.79 | 0.139 | 0.851 | 0.012 | 65.6 | 34.4 | 0.00 | 8.5073 | 1.7410 | 1.0028 | 0.119 | $1.0 \times 10^8$ or more |
| 14 | 22.0 | 11.0 | 11.0 | 0.37 | 4.06 | 0.81 | 0.145 | 0.887 | 0.007 | 82.1 | 17.9 | 0.00 | 8.4104 | 1.8139 | 0.9973 | 0.298 | $1.0 \times 10^8$ or more |
| Example 15 | 22.0 | 11.0 | 11.0 | 0.37 | 4.12 | 0.82 | 0.150 | 0.903 | 0.007 | 99.4 | 0.6 | 0.00 | 8.4947 | 1.9977 | 1.0100 | 0.187 | $7.7 \times 10^7$ |
| Example 16 | 24.0 | 12.0 | 12.0 | 0.40 | 4.05 | 0.81 | 0.151 | 0.930 | 0.006 | 99.5 | 0.5 | 0.00 | 8.4767 | 2.0102 | 1.0076 | 0.180 | $6.8 \times 10^7$ |
| Example 17* | 0.6 | 0.6 | - | 0.02 | 4.17 | 0.81 | 0.323 | 1.882 | 0.538 | 87.3 | 12.7 | 0.00 | 8.4967 | 2.1494 | 1.0002 | 0.134 | $1.9 \times 10^4$ |
| Example 18* | 12 | - | - | - | 3.14 | 0.61 | 0.762 | 2.252 | 0.064 | - | - | - | - | - | - | - | - |
| Example 19* | 12 | - | - | - | 3.33 | 0.61 | 0.669 | 2.077 | 0.056 | - | - | - | - | - | - | - | - |
| Note 1) "*" indicates a comparative example.<br>Note 2) "-" indicates that measurement is not conducted. | | | | | | | | | | | | | | | | | |

Table 6 Properties of magnetic composite

| | Magnetic properties | | | Shape of sample for permeability measurement | Permeability (500 MHz) | | | Permeability (1 GHz) | | | Bendability | | | Adhesion | Curie point of magnetic composite (°C) |
|---|---|---|---|---|---|---|---|---|---|---|---|---|---|---|---|
| | σs (emu/g) | σr (emu/g) | Hc (Oe) | | μ' | μ" | tanδ | μ' | μ" | tanδ | 1/16 (inch) | 1/8 (inch) | 1/4 (inch) | Pencil hardness | |
| Example 1 | 17.7 | 6.4 | 140.9 | Sheet shape | 2.93 | 0.20 | 0.07 | 2.99 | 0.56 | 0.19 | ○ | ○ | ○ | 10H or more | - |
| Example 2 | 17.4 | 6.9 | 148.7 | Sheet shape | 2.43 | 0.39 | 0.16 | 2.74 | 0.60 | 0.22 | ○ | ○ | ○ | 9H | 310 |
| Example 3 | 6.4 | 2.4 | 147.4 | Sheet shape | 2.62 | 0.33 | 0.13 | 2.84 | 0.58 | 0.20 | Δ | ○ | ○ | 8H | - |
| Example 4 | 36.9 | 13.5 | 149.1 | Sheet shape | 2.51 | 0.34 | 0.14 | 2.79 | 0.58 | 0.21 | ○ | ○ | ○ | 5H | - |
| Example 5 | 12.4 | 4.7 | 145.7 | Sheet shape | 2.81 | 0.10 | 0.04 | 2.82 | 0.38 | 0.13 | ○ | ○ | ○ | 4H | - |
| Example 6 | 53.9 | 14.1 | 85.7 | Sheet shape | 1.99 | 0.48 | 0.24 | 1.93 | 0.52 | 0.27 | ○ | ○ | ○ | 9H | - |
| Example 7 | 12.1 | 4.0 | 124.2 | Sheet shape | 3.53 | 0.48 | 0.14 | 3.53 | 1.04 | 0.29 | Δ | ○ | ○ | 10H or more | - |
| Example 8 | 9.7 | 3.0 | 115.8 | Sheet shape | 3.81 | 0.79 | 0.21 | 3.66 | 1.38 | 0.38 | ○ | ○ | ○ | 10H or more | - |
| Example 9 | 5.4 | 2.5 | 235.7 | Sheet shape | 2.36 | 0.11 | 0.05 | 2.19 | 0.18 | 0.08 | ○ | ○ | ○ | 10H or more | - |
| Example 10 | 8.3 | 3.8 | 233.5 | Sheet shape | 2.14 | 0.23 | 0.11 | 2.15 | 0.37 | 0.17 | ○ | ○ | ○ | 10H or more | 180 |
| Example 11 | 1.6 | 0.7 | 141.8 | Sheet shape | 2.88 | 0.53 | 0.18 | 2.87 | 1.21 | 0.42 | ○ | ○ | ○ | 9H | - |
| Example 12 | 4.4 | 2.0 | 269.8 | Sheet shape | 1.83 | 0.10 | 0.05 | 1.79 | 0.04 | 0.03 | ○ | ○ | ○ | 10H or more | - |
| Example 13 | 7.1 | 2.9 | 194.8 | Sheet shape | 2.75 | 0.24 | 0.09 | 2.95 | 0.46 | 0.16 | ○ | ○ | ○ | 10H or more | - |

(continued)

| | Magnetic properties | | | Shape of sample for permeability measurement | Permeability (500 MHz) | | | Permeability (1 GHz) | | | Bendability | | | Adhesion | Curie point of magnetic composite (°C) |
|---|---|---|---|---|---|---|---|---|---|---|---|---|---|---|---|
| | σs (emu/g) | σr (emu/g) | Hc (Oe) | | μ' | μ" | tanδ | μ' | μ" | tanδ | 1/16 (inch) | 1/8 (inch) | 1/4 (inch) | Pencil hardness | |
| Example 14 | 14.2 | 5.2 | 158.3 | Sheet shape | 3.27 | 0.23 | 0.07 | 3.43 | 0.52 | 0.15 | Δ | ○ | ○ | 10H or more | 320 |
| Example 15 | 19.7 | 9.0 | 349.5 | Sheet shape | 2.19 | 0.08 | 0.04 | 2.22 | 0.13 | 0.06 | Δ | ○ | ○ | 10H or more | 470 |
| Example 16 | 12.3 | 5.7 | 321.4 | Sheet shape | 2.31 | 0.10 | 0.04 | 2.34 | 0.14 | 0.06 | Δ | ○ | ○ | 10H or more | - |
| Example 17* | 0.3 | 0.1 | 149.8 | Sheet shape | 1.45 | 0.12 | 0.08 | 1.21 | 0.27 | 0.22 | × | × | × | B | - |
| Example 18* | 40.3 | 2.0 | 50.9 | Sheet shape | 2.84 | 1.34 | 0.47 | 2.01 | 1.53 | 0.76 | × | × | × | - | Note 3 |
| Example 19* | 26.9 | 2.0 | 59.2 | Sheet shape | 1.82 | 0.66 | 0.37 | 1.42 | 0.82 | 0.58 | × | × | × | - | Note 3 |
| Note 1) "*" indicates a comparative example. Note 2) "-" indicates that measurement is not conducted. Note 3) When the temperature exceeded 200°C, the resin was decomposed and could not be measured. | | | | | | | | | | | | | | | |

INDUSTRIAL APPLICABILITY

According to the present invention, a magnetic composite including a ferrite layer that is dense, has a relatively large thickness, is excellent in magnetic properties and electrical properties, and further has good adhesion can be provided.

The present invention has been described in detail with reference to specific embodiments, but it is apparent to those skilled in the art that various changes and modifications can be made without departing from the spirit and scope of the present invention.

The present application is based on the Japanese patent application (Japanese Patent Application No. 2021-004514) filed on January 14, 2021 and the Japanese patent application (Japanese Patent Application No. 2022-001607) filed on January 7, 2022, and the contents thereof are incorporated herein by reference.

REFERENCE SIGNS LIST

2: aerosolization chamber
4: film formation chamber
6: conveying gas source
8: vacuum evacuation system
10: vibrator
12: raw material container
14: nozzle
16: stage
20: aerosol deposition film forming device

**Claims**

1. A magnetic composite comprising a metal base material and a ferrite layer provided on a surface of the metal base material, wherein

   the metal base material has a thickness ($d_M$) of 0.001 $\mu$m or more, and
   the ferrite layer has a thickness ($d_F$) of 2.0 $\mu$m or more, contains spinel-type ferrite as a principal component, and has a ratio ($I_{222}/I_{311}$) of 0.00 or more and 0.03 or less, the ratio being of an integrated intensity ($I_{222}$) of a (222) plane to an integrated intensity ($I_{311}$) of a (311) plane in X-ray diffraction analysis.

2. The magnetic composite according to claim 1, wherein
   in the ferrite layer, a content of $\alpha$-$Fe_2O_3$ is 0.0 mass% or more and 20.0 mass% or less.

3. The magnetic composite according to claim 1 or 2, wherein
   the ferrite layer contains iron (Fe) and oxygen (O), and further contains at least one element selected from the group consisting of lithium (Li), magnesium (Mg), aluminum (Al), titanium (Ti), manganese (Mn), zinc (Zn), nickel (Ni), copper (Cu), and cobalt (Co).

4. The magnetic composite according to any one of claims 1 to 3, wherein
   in the ferrite layer, a ratio ($Ra/d_F$) of a surface arithmetic average rouglmess (Ra) to the thickness ($d_F$) is more than 0.00 and 0.20 or less.

5. The magnetic composite according to any one of claims 1 to 4, wherein
   the ferrite layer has a composition including a ferrite component and the remainder being inevitable impurities.

6. An element or component having a coil and/or an inductor function, an electronic device, an electronic component accommodation housing, an electromagnetic wave absorber, an electromagnetic wave shield, or an element or component having an antenna function, which comprises the magnetic composite according to any one of claims 1 to 5.

*FIG. 1*

FERRITE FILM

INORGANIC BASE MATERIAL

*FIG. 2*

FERRITE FILM

INORGANIC BASE MATERIAL

## FIG. 3

FERRITE FILM

FERRITE FILM

INORGANIC BASE MATERIAL

## FIG. 4

FERRITE FILM

INORGANIC BASE MATERIAL

FIG. 5

COIL (SPIRAL SHAPE, METAL)

FERRITE FILM

BASE MATERIAL (METAL)
SERVING AS ELECTRODE

THROUGH ELECTRODE
(FROM SPIRAL COIL TO BASE MATERIAL SIDE ELECTRODE)

FIG. 6

FERRITE FILM

BASE MATERIAL (METAL)
SERVING AS ELECTRODE ①

DIELECTRIC

INDUCTOR ELECTRODE ③

CAPACITOR ELECTRODE ② (METAL)

EP 4 280 234 A1

*FIG. 7*

(a)

(b)

INDUCTOR ELECTRODE

INDUCTOR ELECTRODE

FIG. 8

INDUCTOR
ELECTRODE a

INDUCTOR
ELECTRODE b

INDUCTOR
ELECTRODE c

INDUCTOR
ELECTRODE d

INDUCTOR
ELECTRODE e

INDUCTOR
ELECTRODE A

INDUCTOR
ELECTRODE B

EXTERNAL
ALTERNATING-CURRENT
MAGNETIC FIELD H

FIG. 9

ANTENNA PATTERN (METAL CONDUCTOR)

FERRITE FILM

ID TAG CHIP

# FIG. 10

FERRITE FILM
FERRITE FILM
FERRITE FILM
FERRITE FILM
FERRITE FILM
FERRITE FILM

INORGANIC BASE MATERIAL (METAL)

INORGANIC BASE MATERIAL
(BASE MATERIAL HAVING GOOD THERMAL CONDUCTIVITY)

FIG. 11

INORGANIC
BASE MATERIAL
(METAL)

FERRITE FILM

ELECTRONIC
COMPONENT
(NOISE)

FERRITE FILM

INORGANIC
BASE MATERIAL
(METAL)

## FIG. 12

SIGNAL LINE

RESIN LAYER
(INSULATING LAYER)

FERRITE FILM

INORGANIC
BASE MATERIAL
(METAL)

FERRITE FILM

RESIN LAYER
(INSULATING LAYER)

## FIG. 13

(a)

(b)

(c)

FIG. 14

ANTENNA PATTERN
(METAL CONDUCTOR)

ID TAG CHIP A    FERRITE FILM
(COMPOSITION A)

ANTENNA PATTERN
(METAL CONDUCTOR)

ID TAG CHIP B    FERRITE FILM
(COMPOSITION B)

ANTENNA PATTERN
(METAL CONDUCTOR)

ID TAG CHIP C    FERRITE FILM
(COMPOSITION C)

FIG. 15

*FIG. 16*

(a)
ELECTRONIC IMAGE 1

(b)
CKα1_2

(c)
Cu Lα1_2

(d)
Fe Kα1

(e)
Mn Kα1

(f)
O Kα1

10μm

FIG. 17

M (emu)

EXAMPLE 2

0.1

0

-0.02

T (°C)

500

FIG. 18

M (emu)

EXAMPLE 10

0.1

0

-0.02

T (°C)

500

*FIG. 19*

*FIG. 20*

FIG. 21

○ μ'
△ μ"

## INTERNATIONAL SEARCH REPORT

| International application No. |
|---|
| **PCT/JP2022/000988** |

### A. CLASSIFICATION OF SUBJECT MATTER

***H01F 10/20***(2006.01)i; ***H01F 1/00***(2006.01)i; ***H01F 1/34***(2006.01)i; ***H01Q 17/00***(2006.01)i; ***H05K 9/00***(2006.01)i
FI:  H01F10/20; H05K9/00 M; H01F1/34 140; H01F1/00 127; H01Q17/00

According to International Patent Classification (IPC) or to both national classification and IPC

### B. FIELDS SEARCHED

Minimum documentation searched (classification system followed by classification symbols)

H01F10/20; H01F1/00; H01F1/34; H01Q17/00; H05K9/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

JSTPlus/JMEDPlus/JST7580 (JDreamIII)

### C. DOCUMENTS CONSIDERED TO BE RELEVANT

| Category* | Citation of document, with indication, where appropriate, of the relevant passages | Relevant to claim No. |
|---|---|---|
| X | JP 2007-204817 A (JFE STEEL KK) 16 August 2007 (2007-08-16)<br>paragraphs [0022]-[0033] | 1-6 |
| X | JP 2003-297629 A (SONY CORP.) 17 October 2003 (2003-10-17)<br>paragraphs [0024]-[0057] | 1-6 |
| A | JP 2004-296609 A (NATIONAL INST. OF ADVANCED INDUSTRIAL & TECHNOLOGY)<br>21 October 2004 (2004-10-21)<br>paragraphs [0008]-[0028] | 1-6 |

☐ Further documents are listed in the continuation of Box C.    ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **21 February 2022** | **08 March 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2022/000988**

| Patent document cited in search report | | | Publication date (day/month/year) | Patent family member(s) | Publication date (day/month/year) |
|---|---|---|---|---|---|
| JP | 2007-204817 | A | 16 August 2007 | (Family: none) | |
| JP | 2003-297629 | A | 17 October 2003 | (Family: none) | |
| JP | 2004-296609 | A | 21 October 2004 | WO 2004/086430 A1 page 6, line 5 to page 12, line 11 | |

Form PCT/ISA/210 (patent family annex) (January 2015)

**REFERENCES CITED IN THE DESCRIPTION**

**Patent documents cited in the description**

- JP 2004027064 A
- JP 2005045193 A
- JP 2007088121 A
- JP 2007180289 A

- JP 2007250924 A
- JP 2021004514 A
- JP 2022001607 A